# EUROPEAN PATENT SPECIFICATION

(11) **EP 2 937 888 B1**
(45) Date of publication and mention of the grant of the patent: **20.02.2019**
(21) Application number: 15164770.8
(22) Date of filing: 23.04.2015
(51) Int. Cl.: H01J 37/30, H01J 37/317

(54) **MULTI-BEAM TOOL FOR CUTTING PATTERNS**
MEHRSTRAHLIGES WERKZEUG ZUM SCHNEIDEN VON MUSTERN
OUTIL MULTI-FAISCEAUX POUR MOTIFS DE DÉCOUPE

(30) Priority: 25.04.2014 EP 14165967
(43) Date of publication of application: 28.10.2015
(73) Proprietor: IMS Nanofabrication GmbH, 1020 Wien (AT)
(72) Inventor: Platzgummer, Elmar, 1090 Wien (AT); Loeschner, Hans, 1190 Wien (AT)
(74) Representative: Patentanwaltskanzlei Matschnig & Forsthuber OG

(56) References cited:
- EP-A1- 2 019 415
- EP-A2- 2 317 535
- GB-A- 2 349 737
- US-A1- 2005 242 302
- US-A1- 2005 242 303
- US-B1- 6 472 673
- US-B2- 7 214 951

## Description

### Field of the invention and description of prior art

The invention relates to a programmable charged-particle multi-beam apparatus for processing (in particular nanopatterning or semiconductor lithography) or inspection of a target. More in detail, the invention relates to a charged-particle multi-beam processing apparatus for exposure of a target with a plurality of beams of electrically charged particles, comprising a plurality of particle-optical columns arranged parallel and configured for directing a respective particle beam towards the target, wherein each particle-optical column comprises an illumination system, a beam shaping device and a projection optics system. The illumination system serves to produce a respective beam and form it into a (preferably, substantially telecentric) beam illuminating the beam shaping device. The beam shaping device is configured to form the shape of the illuminating beam into a desired pattern composed of a multitude of sub-beams, and includes an aperture array device provided with a multitude of apertures, each of said apertures defining the shape of a respective sub-beam having a nominal path towards the target, as well as a deflection array device for deflecting (only) selected sub-beams off their respective nominal path so that sub-beams thus selected do not reach the target; the remaining sub-beams represent the desired pattern being imaged to the target. The projection optics system serves to project an image of the beam shape defined in the beam shaping device onto the target. Furthermore, the invention also relates to a beam shaping device (also called pattern definition device) for use in a column of such a charged-particle multi-beam processing apparatus, configured to be irradiated by an illuminating beam of electrically charged particles and to form the shape of the illuminating beam into a desired pattern composed of a multitude of sub-beams.

This type of multi-column (or "multi-axis") configuration is described in US 7,214,951 and US 8,183,543 of the applicant.

The applicant has developed several solutions and techniques suitable in the field of charged-particle multi-beam lithography and nanopatterning and pertinent technology, such as the following: when using ion multi-beams coined CHARPAN (charged particle nanopatterning) and when using electron multi-beams coined eMET (electron mask exposure tool) or MBMW (multi-beam mask writer) for mask writing, and coined PML2 (Projection Mask-Less Lithography) for direct write lithography on substrates, in particular silicon wafers. In this context, relevant patent documents in the name of the applicant are US 7,199,373, US 7,214,951, US 8,304,749, US 8,183,543, and US 8,222,621.

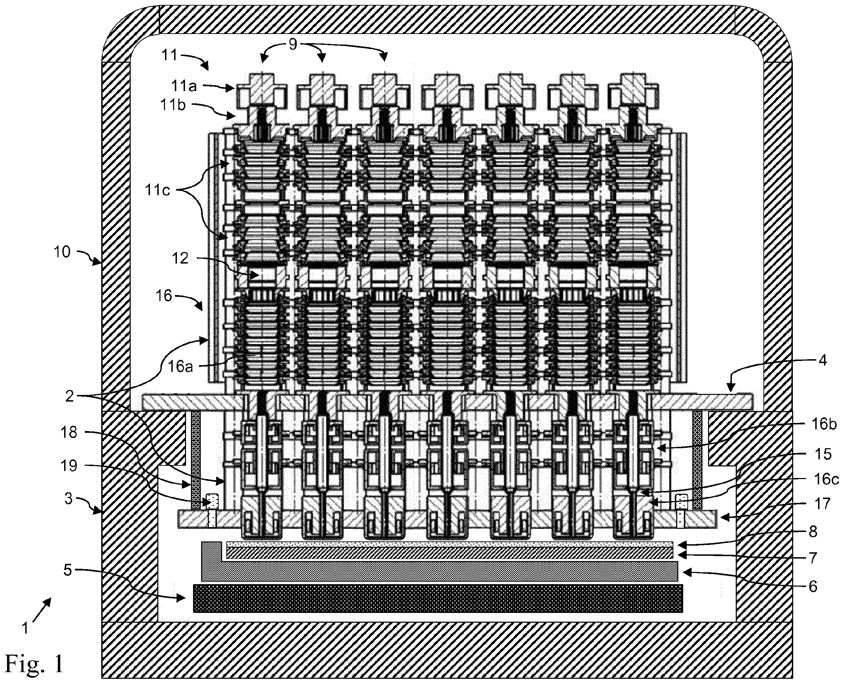

Fig. 1 shows a schematic sectional view of a multi-column writer tool 1 with vacuum housing 10 for the multi-column charged-particle optics 2, a target chamber 3 onto which the multi-column charged-particle optics is mounted by means of a column base plate 4. Within the target chamber 3 is an X-Y stage 5, e.g. a laser-interferometer controlled air-bearing vacuum stage onto which a substrate chuck 6 is loaded using a suitable handling system. The chuck 6, which preferably is an electrostatic chuck, holds the substrate 7, such as a silicon wafer. For charged-particle multi-beam lithography the substrate, for instance, is covered with an electron or ion beam sensitive resist layer 8.

The multi-column optics 2 comprises a plurality of sub-columns 9 (the sub-columns 9 correspond to the "columns" as claimed in the claims; the number of columns shown is reduced in the depiction for better clarity, and represent a much larger number of columns that are present in the multi-column apparatus in a realistic implementation). Preferably, the sub-columns 9 have identical setup and are installed side-by-side with mutually parallel axes. Each sub-column has an illuminating system 11 including an electron or ion source 11a, an extraction system 11b, and an electrostatic multi-electrode condenser optics 11c, delivering a broad telecentric charged-particle beam to a pattern definition device (PDD) 12 being adapted to let pass the beam only through a plurality of apertures defining the shape of sub-beam ("beamlets") permeating said apertures, and a demagnifying charged-particle projection optics 16 comprising three lenses: In the embodiment shown, the first lens is an accelerating electrostatic multi-electrode lens 16a whereas the second and third lenses 16b, 16c are either magnetic lenses, in particular when using electrons, or electrostatic lenses, for instance in the case where the particles are ions, as outlined in US 7,214,951.

The accelerating first lens of the projection charged-particle optics 16 provides the important advantage of operating the PDD 12 at low kinetic energy of the particles (e.g. 5 keV) whereas providing high beam energy (e.g. 50 keV) at the cross-overs of the demagnifying projection optics, thus minimizing stochastic Coulomb interactions. Further, the high beam energy at the substrate is beneficial to reduce forward scattering of the charged particles when exposing the target, in particular the charged-particle sensitive layer 8.

The first lens of the projection optics forms a first cross-over whereas the second lens forms a second cross-over. At this position in each sub-column there is a stopping plate 15 configured to filter out beams deflected in the PDD. The third lenses 16c of the sub-columns as well as the stopping plates 15 are mounted onto a reference plate 17 which is mounted by suitable fastening means 18 onto the column base plate 4. Mounted onto the reference plate 17 are parts 19 of an off-axis optical alignment system.

The reference plate is fabricated from a suitable base material having low thermal expansion, such as a ceramic material based on silicon oxide or aluminum oxide, which has the advantage of little weight, high elasticity module and high thermal conductivity, and may suitably be covered with an electrically conductive coating, at least at its relevant parts, in order to avoid charging (by allowing electrostatic charges being drained off).

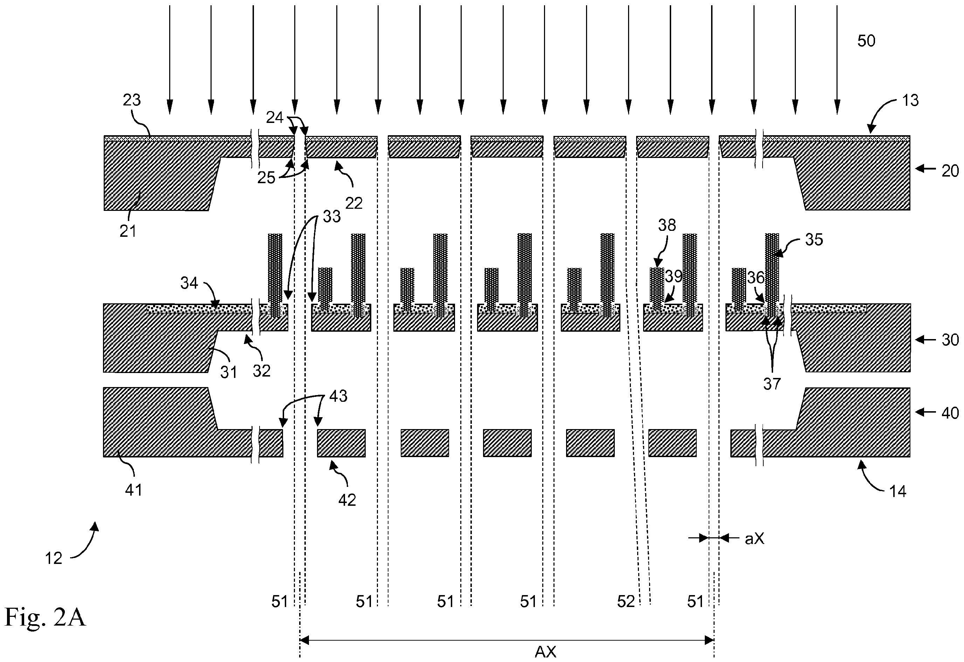

As can be seen in the sectional detail of Fig. 2A, the PDD 12 preferably comprises three plates stacked in a consecutive configuration: An "Aperture Array Plate" (AAP) 20, a "Deflection Array Plate" (DAP) 30 and a "Field-boundary Array Plate" (FAP) 40. It is worthwhile to note that the term 'plate' refers to an overall shape of the respective device, but does not necessarily indicate that a plate is realized as a single plate component even though the latter is usually the preferred way of implementation; still, in certain embodiments, a 'plate', such as the aperture array plate, may be composed of a number of sub-plates. The plates are preferably arranged parallel to each other, at mutual distances along the Z direction.

The flat upper surface of AAP 20 forms a defined potential interface to the condenser optics/illumination system 11. The AAP may, e.g. be made from a square or rectangular piece of a silicon wafer (approx. 1mm thickness) 21 with a thinned center part 22. The plate may be covered by an electrically conductive protective layer 23, which will be particularly advantageous when using hydrogen or helium ions (as in US 6,858,118). When using electrons or heavy ions (e.g. argon or xenon), the layer 23 may also be silicon, provided by the surface section of 21 and 22, respectively, so that there is no interface between layer 23 and bulk parts 21 / 22, respectively.

The AAP 20 is provided with a plurality of apertures 24 formed by openings traversing the thinned part 22. In the embodiment shown the apertures 24 are realized having a straight profile fabricated into the layer 23 and a "retrograde" profile in the bulk layer of the AAP 20 such that the downward outlets 25 of the openings are wider than in the main part of the apertures 24. Both the straight and retrograde profiles can be fabricated with state-of-the-art structuring techniques such as reactive ion etching. The retrograde profile strongly reduces mirror-charging effects of the beam passing through the opening.

The DAP 30 is a plate provided with a plurality of openings 33, whose positions correspond to those of the apertures 24 in the AAP 20, and which are provided with electrodes 35, 38 configured for deflecting the individual sub-beams passing through the openings 33 selectively from their respective paths. The DAP 30 can, for instance, be fabricated by post-processing a CMOS wafer with an ASIC circuitry. The DAP 30 is, for instance, made from a piece of a CMOS wafer having a square or rectangular shape and comprises a thicker part 31 forming a frame holding a center part 32 which has been thinned (but may be suitably thicker as compared to the thickness of 22). The aperture openings 33 in the center part 32 are wider compared to 24 (by approx. 2µm at each side for instance). CMOS electronics 34 is used to control the electrodes 35, 38, which are provided by means of MEMS techniques. Adjacent to each opening 33, a "ground" electrode 35 and a deflection electrode 38 are provided. The ground electrodes 35 are electrically interconnected, connected to a common ground potential, and comprise a retrograde part 36 to prevent charging and an isolation section 37 in order to prevent unwanted shortcuts to the CMOS circuitry. The ground electrodes 35 may also be connected to those parts of the CMOS circuitry 34 which are at the same potential as the silicon bulk portions 31 and 32.

The deflection electrodes 38 are configured to be selectively applied an electrostatic potential; when such electrostatic potential is applied to an electrode 38, this will generate an electric field causing a deflection upon the corresponding sub-beam, deflecting it off its nominal path. The electrodes 38 as well may have a retrograde section 39 in order to avoid charging. Each of the electrodes 38 is connected at its lower part to a respective contact site within the CMOS circuitry 34.

The height of the ground electrodes 35 is higher than the height of the deflection electrodes 38 in order to suppress cross-talk effects between the beams.

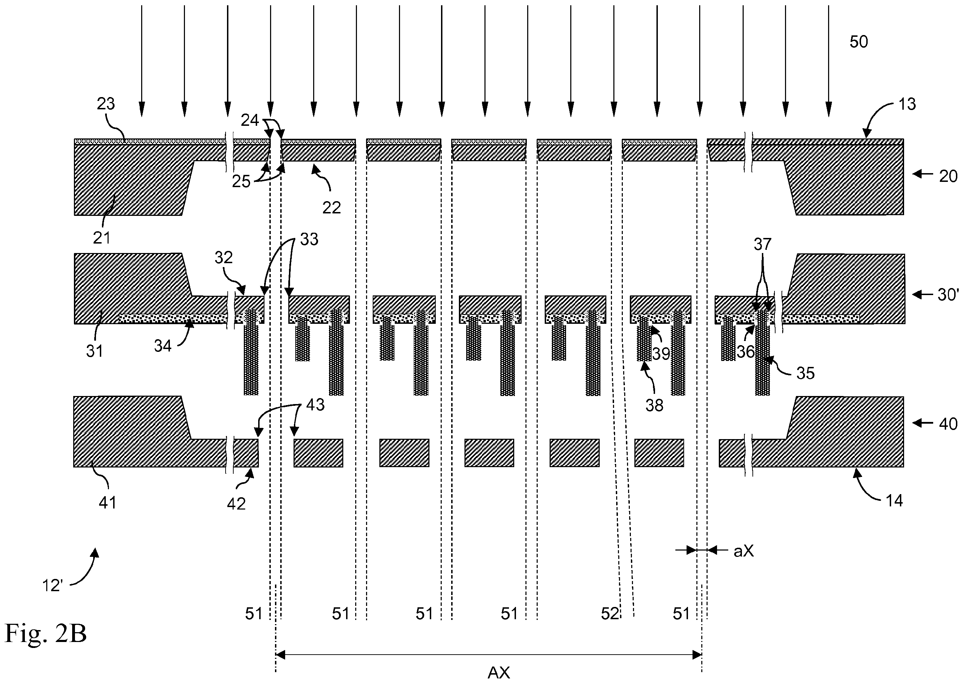

The arrangement of a PDD 12 with a DAP 30 having electrodes oriented upstream as shown in Fig. 2A is only one of several possibilities. As shown in Fig. 2B, a variant PDD 12' may have an inverted DAP 30' arranged such that the flat surface with the CMOS circuitry 34 are facing upward, whereas the ground and deflection electrodes 35, 38 are oriented downstream.

Further DAP configurations, e.g. with embedded ground and deflection electrodes, can easily be devised by the skilled person (see other patents in the name of the applicant, such as US 8,198,601 B2).

The third plate 40 serving as FAP has a flat surface facing to the first lens part of the downstream demagnifying charged-particle projection optics and thus provides a defined potential interface to the first lens 16a of the projection optics. The thicker part 41 of FAP 40 is a square or rectangular frame made from a part of a silicon wafer, with a thinned center section 42. The FAP 40 is provided with a plurality of openings 43, which correspond to the openings 24, 33 of the AAP 20 and DAP 30 but are wider as compared to the latter.

The PDD 12, and in particular the first plate of it, the AAP 20, is illuminated by a broad charged particle beam 50 (herein, "broad" beam means that the beam is sufficiently wide to cover the entire area of the aperture array formed in the AAP), which is thus divided into many thousands of micrometer-sized beams 51 when transmitted through the apertures 24. The beams 51 will traverse the DAP and FAP unhindered.

As already mentioned, whenever a deflection electrode 38 is powered through the CMOS electronics, an electric field will be generated between the deflection electrode and the corresponding ground electrode, leading to a small but sufficient deflection of the respective beam 52 passing through (Fig. 2A). The deflected beam can traverse the DAP and FAP unhindered as the openings 33 and 43, respectively, are made sufficiently wide. However, the deflected beam 52 is filtered out at the stopping plate 15 of the sub-column (Fig. 1). Thus, only those beams which are unaffected by the DAP will reach the substrate.

The reduction factor of the demagnifying charged-particle optics 16 is chosen suitably in view of the dimensions of the beams and their mutual distance in the PDD 12 and the desired dimensions of the structures at the target. This will allow for micrometer-sized beams at the PDD whereas nanometer-sized beams are projected onto the substrate.

The ensemble of (unaffected) beams 51 as formed by AAP is projected to the substrate with a predefined reduction factor R of the projection charged-particle optics. Thus, at the substrate a "beam array field" (BAF) is projected having widths BX = AX/R and BY = AY/R, respectively, where AX and AY denote the sizes of the aperture array field along the X and Y directions, respectively. The beam size of an individual beam at the substrate is given by bX = aX/R and bY = aY/R, respectively, where aX and aY denote the sizes of the beam 51 as measured along the X and Y directions, respectively, at the level of the DAP 30.

It is worthwhile to note that the individual beams 51, 52 depicted in Figs. 2A and 2B (as well as in the analogous figures below) represent a much larger number of sub-beams, typically many thousands, arranged in a two-dimensional X-Y array. The applicant has, for instance, realized multi-beam charged-particle optics with a reduction factor of R = 200 for ion as well as electron multi-beam columns with many thousands (e.g., 262,144) programmable beams. The applicant has realized such columns with a beam array field of approx. 82µm x 82µm at the substrate. These examples are stated for illustrative purpose, but are not to be construed as limiting examples.

The arrangement outlined in Figs. 2 is used to implement sub-columns with such a diameter that a large number of sub-columns of the above-described kind fit within the area of a substrate, such as a 300mm silicon wafer which is used as a substrate for leading-edge integrated circuit device production. There is ongoing development of 193nm immersion optical lithography, EUV and nano-imprint lithography tools for 450mm silicon wafer size. Without loss of throughput, the multi-column configuration as presented here can be adapted to any other wafer size, such as a 450mm diameter silicon wafer size, by providing a corresponding higher number of sub-columns.

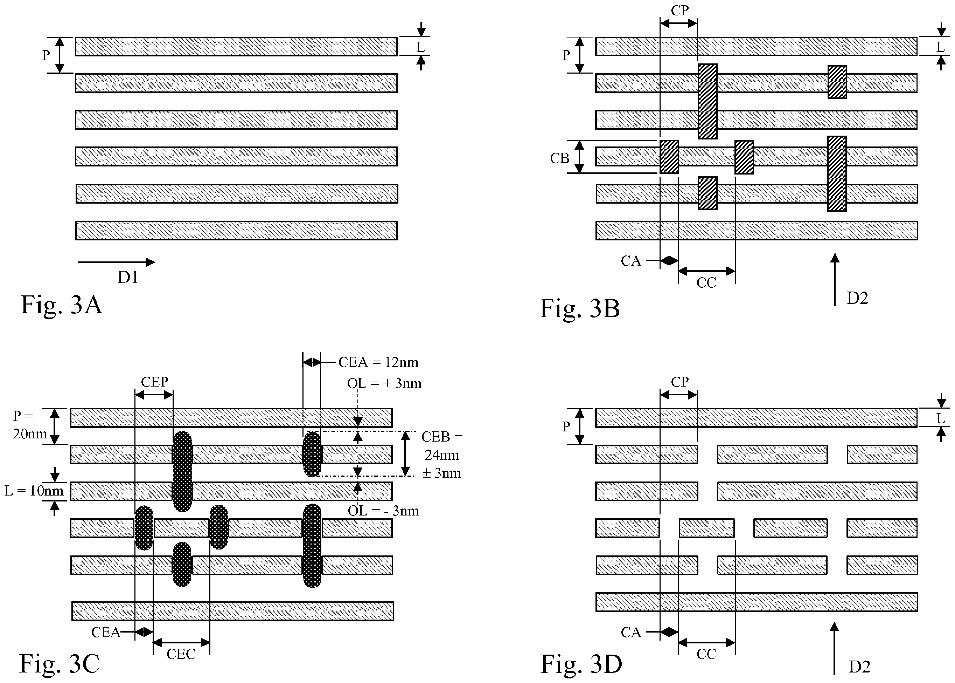

The recent progress of integrated circuits, in particular microprocessors, was made possible not only by novel lithographic, deposition, and etching techniques, but also by innovative circuit design. A most powerful innovation was to proceed from a two-dimensional to a one-dimensional circuit design, as was described by Yan Borodovsky in "EUV, EBDW - ARF Replacement or Extension?", KLA-Tencor Lithography User Forum, Feb 21, 2010, San Jose, CA, USA. For this end regular line patterns (Fig. 3A) running along a uniform line grid direction D1 are fabricated using 193nm (water) immersion optical lithography, layer deposition and etching steps. Then, "complementary lithography" exposure is performed to induce cuts (Fig. 3B) along a perpendicular direction D2 ("cut direction") by employing corresponding resist exposure and resist development (Fig. 3C), and subsequent etching steps to accomplish the cuts in the regular line pattern (Fig. 3D). Thus, each cut represents a break in the respective line.

The current requirements of the semiconductor industry for various dimension parameters such as the minimum feature size CA, CB of the cutting pattern are listed in Table 1.

**Table 1**

| Logic Node | Year of production | P | L | CA | CB | CDU 3 sigma | OL 3 sigma | CD | CP | Pattern Density |
|---|---|---|---|---|---|---|---|---|---|---|
| 10nm | 2015 | 40nm | 20nm | 20nm | NA | NA | NA | 60nm | 40nm | NA |
| 7nm | 2017 | *28nm* | *14nm* | 16nm | 32nm | 4nm | 4nm | *38nm* | *28nm* | 10% |
| 5nm | 2019 | *20nm* | *10nm* | 12nm | 24nm | 3nm | 3nm | *26nm* | *20nm* | 10% |
| 3nm | 2021 | *14nm* | *7nm* | 9nm | 18nm | 2.2nm | 2.2nm | *17nm* | *14nm* | 10% |

The numbers in normal typeface in Table 1 were taken from the above-cited reference in KLA-Tencor Lithography User Forum as well as the slide presentation of Yan Borodovsky in "MPProcessing for MPProcessors", SEMATECH Maskless Lithography and Multibeam Mask Writer Workshop, May 10, 2010, New York, NY, USA. The italic numbers are deduced values; e.g. it is indicated in the reference in KLA-Tencor Lithography User Forum that P and L scale with a factor of 0.71 from node to node.

The required Critical Dimension Uniformity (CDU) and the overlay (OL) of the minimum cutting pattern with the critical dimension CA are also indicated in Table 1. The minimum distance CC between cutting patterns and minimum periodicity CP of cutting patterns, as defined in Fig. 3B, are also indicated in Table 1.

To date, development of EUV (extended ultra-violet) lithography, based on 13.5nm wavelength, is delayed, and therefore, in 2015 there will be the necessity to expose the cutting pattern with 193nm immersion optical lithography. The minimum pitch of the 193nm immersion scanner lithographic technique is ca. 80nm. As a consequence there is the need to expose the cutting pattern with 4 different masks, as outlined in the above-cited reference in KLA-Tencor Lithography User Forum as CP = 40nm for the 10nm logic technology node (Table 1). EUV lithography with a numerical aperture of NA = 0.25 provides better resolution capabilities. As a consequence, for the 10nm logic technology node the EUV exposure of the cutting pattern could be possible with one mask. Therefore, there is continued strong industrial interest in EUV lithography. However, the entry of EUV lithography is likely to be pushed up to the 10nm or 7nm logic node. Still, there are major hurdles for EUV lithography to overcome, which is why semiconductor industry is increasingly and seriously interested in alternative lithographic possibilities for cutting pattern exposure. Nano-imprint lithography is one possibility, but there are several difficulties, such as master template fabrication, lifetime of working stamp replicas, defect inspection and repair of the stamps, and the possible occurrence of defect generation during imprinting. As another alternative, electron multi-beam direct write has obtained high industrial attention and interest because it offers sub-10nm resolution potential and no masks are needed.

In view of the above, there is the need for an improved multi-beam tool allowing an efficient approach to write structures in a one-dimensional circuit design.

### Summary of the invention

This aim is met by a charged-particle multi-beam processing apparatus as defined in claim 1 and a method for exposure of a target as defined in claim 15, wherein, for a target comprising a line pattern oriented along a given line grid direction and in order to perform the exposure of the target with respect to this line grid direction, the pattern definition device includes
- an aperture array device provided with an array of apertures, said array of apertures comprising a multitude of apertures, each of which defines the shape of a respective sub-beam having a nominal path towards the target, and
- a deflection array device, configured to deflect selected sub-beams off their respective nominal path so that sub-beams thus selected do not reach the target,
wherein the apertures in said array of apertures are configured to form an oblong shape as seen along the direction of the beam, said oblong shape having a short and a long side, with the long side being at least the double of the short side, wherein the oblong shape formed by the apertures is oriented traversing the line grid direction. For instance, the beam shaping device may be orientable with respect to said line grid direction such that the aperture oblong shape is oriented traversing the line grid direction.

With this solution the sub-beams are given a shape enabling the definition of cut shapes on the target. This will considerably reduce the processing time for the underlying layouts to be produced on the target. Generally, for a target to be processed, such as a silicon wafer with a line pattern as mentioned above, the orientation of the line pattern is known beforehand, i.e. prior to loading the target into the multi-beam processing apparatus. Methods to specify and determine the orientation are well known, for instance by means of a notch of a round wafer. Thus, the target is loaded into the multi-beam processing apparatus with a well-defined and predetermined orientation of the line grid direction. In addition, a "pre-aligner" may be used to achieve an adequate orientation, which detects the actual orientation of the wafer and adjusts it as required. As a variant, the line grid direction (for instance, along the X- or Y-direction of the apparatus) may be defined for each target to be processed, for instance as an input parameter to be specified at the start of each respective writing process.

With this solution the sub-beams are given a shape enabling the definition of cut shapes on the target. This will considerably reduce the processing time for the underlying layouts to be produced on the target.

Generally, for a target to be processed, such as a silicon wafer with a line pattern as mentioned above, the orientation of the line pattern is known beforehand from the printed layout, i.e. prior to loading the target into the multi-beam processing apparatus. The line grid direction (for instance, along the X- or Y-direction of the apparatus) may thus be defined for each target to be processed, for instance as an input parameter to be specified at the start of each respective writing process. Furthermore, methods to specify and determine the orientation of the substrate as well as the structures that it carries are well known. For example, well-defined structures written beforehand and the orientation thereof may be recorded by means of a signal of secondary electrons generated therefrom by the incoming primary lithography beam. Thus, the target may be loaded into the multi-beam processing apparatus with a well-defined and predetermined orientation of the line grid direction.

In a first aspect of the invention, the apertures in the aperture array device directly define the shape of the respective sub-beams. Thus, in this case, the apertures in an array of apertures have an oblong shape, which may be formed according to the desired shape of a cut line, for instance. According to a suitable choice, the long side of the oblong shape will be at least the double of the short side of said oblong shape and oriented traversing a line grid direction of a line pattern of the target.

An alternative aspect realizes a composite aperture array device, which comprises two (or more) consecutive plates. These plates are suitably arranged parallel within the pattern definition device and preferably in immediate order to each other. Each plate may have an array of apertures with the apertures of the plates mutually corresponding and cooperating to form a shape of the corresponding sub-beam, said shape being defined by the relative position of the plates as seen along the direction of the beam. In a further development of this aspect, these plates may be provided with positioning devices to modify the relative position of the plates transversal to the direction of the beam, which will allow defining variable shapes with one composite aperture array device.

In a suitable development of the invention, the oblong shape of the apertures may be uniformly oriented along a specific direction for each array of apertures on the aperture array devices of each respective column. (Herein the term "columns" and "sub-columns" are used indiscriminately to denote the individual columns of the multi-column device.) Furthermore, the aperture array devices (or at least a number of them) may be provided with at least two interlacing arrays of apertures, wherein the oblong shapes within each array are uniformly oriented along a direction specific to the respective array, the specific directions of the arrays being mutually different. In particular, each of the aperture array device may be provided with two interlacing arrays of apertures, wherein the oblong shapes within a first array are uniformly oriented along a first direction, and within a second array along a second direction transversal to the first direction. This allows an efficient processing of target layouts comprising regions of different line orientations.

Another development combines the invention with a general patterning procedure in a very flexibly manner. In this case, at least part of the aperture array devices may be additionally provided with an array of non-oblong apertures, said non-oblong aperture having a shape differing from the shape of the oblong apertures, preferably square, circular or hexagonal, said array of non-oblong apertures interlacing with the array of oblong apertures.

Another approach uses different orientations of the apertures for different columns. Thus, advantageously, while for each column the oblong shape of the apertures is uniformly oriented within the respective aperture array device, a first group of columns may have the oblong shapes oriented along a first direction, but a second group may have the oblong shapes oriented along a second direction transversal to the first direction. Preferably, the second direction may be orthogonal to the first direction.

Each column has a projection optics system which projects an image onto the target wherein the image may include an isotropic or anisotropic blur. Another development of the invention employs an anisotropic blur generated by the projection optics system and having an axis of maximum blur oriented along a direction corresponding to the long side of the oblong shape of the apertures in the respective aperture array device and an axis on minimum blur oriented along the opposite direction. This contributes to a high definition of the position of cut lines along the line direction, while ensuring that each cut line properly interrupts the respective line.

In conjunction with a stage for positioning the target with regard to the plurality of particle-optical columns, another possible advantage of the invention is the efficient use of the multi-column system for simultaneous multiple writing of the target. In particular, the target stage may be configured to move the target through a sequence of positions, such that each column produces a set of images on the target within a predefined respective column exposure area, wherein the column exposure areas of the columns combine into a covering of a target exposure area on the target. Thus, each column writes into a specific area on the target (only), which facilitates implementation and calculation of the corresponding writing patterns. For instance, the column exposure area of a column may correspond to the area of one die field on the target. Alternatively, the column exposure area of a column may correspond to an area of two adjacent die fields on the target; in subsequent writing steps, the association of two die fields, respectively, to one column may vary. With this, it is possible to realize a very compact tool configuration which is of high importance when aiming to cluster several tools within a given clean room area.

Furthermore, in order to facilitate the access to the individual columns for providing them with the pattern data for the writing process, the plurality of particle-optical columns may be arranged in a two-dimensional arrangement wherein along (at least) one direction of the two-dimensional arrangement the columns are spaced apart by a column offset forming aisles, said column offset being at least the doubled width of the minimal pitch between adjacent columns within the arrangement.

Another aspect of the invention improves the quality of the shape of the sub-beams by providing a clean interface between the pattern definition device and the other optical components. Namely, the respective pattern definition device may include (i) a first boundary device as the first element of the pattern definition device as seen along the direction of the beam, the first boundary device having a first surface oriented towards the illumination system, and (ii) a final plate device as the last element of the pattern definition device as seen along the direction of the beam, the final plate device having a final surface oriented towards the projection optics system. Advantageously, the first and final surfaces are flat - with the exception of a respective array of openings corresponding to the apertures of the aperture array device of the respective pattern definition device. In particular, the first boundary device may be realized by the aperture array device itself, or by a separate plate-shaped device.

### Brief description of the drawings

In the following, the present invention is described in more detail with reference to the drawings, which illustrate several embodiments of the invention given by way of example and representing suitable implementations of the invention, which are not to be construed as restrictive to invention. The drawings schematically show:
- Fig. 1: a schematic sectional view of a multi-column writer tool;
- Fig. 2A: a sectional view of a pattern definition device of one of the columns of the tool of Fig. 1, having deflecting electrode oriented upstream;
- Fig. 2B: a variant of the pattern definition device with electrodes oriented downstream;
- Figs. 3A to 3D: illustrate a one-dimensional circuit design and several dimension parameters defined in such a layout;
- Fig. 4A: shows a first arrangement of the columns with regard to the target in a partial plan view (rectangular arrangement);
- Fig. 4B: shows a second arrangement of the columns (rhombic arrangement);
- Figs. 5A and 5B: shows plan view details of an aperture array plate and a deflection array plate according to a first embodiment of the invention;
- Figs. 6A and 6B: illustrate the exposure of target shot sites with square aperture images according to prior art;
- Figs. 7A and 7B: illustrate exposure of target shot sites according to the invention;
- Fig. 8: shows simulation results of various intensity profiles corresponding to different line widths between 7.5nm and 12.25nm in steps of 0.25nm;
- Fig. 9: shows simulation results of various intensity profiles corresponding to different line widths between 15.0nm and 25.0nm in steps of 0.5nm;
- Fig. 10: shows the arrangement of columns in a cross sectional view at the level of the pattern definition device, for a rectangular arrangement;
- Fig. 11: illustrates an exposure of a wafer with the arrangement of columns of Fig. 10;
- Fig. 12: illustrates the writing exposure of a die area by one sub-column for the arrangement of Fig. 10;
- Fig. 13: shows the arrangement of columns in a cross sectional view at the level of the pattern definition device, for a rhombic arrangement;
- Fig. 14: illustrates an exposure of a wafer with the arrangement of columns of Fig. 13;
- Fig. 15: illustrates the writing exposure of a die area by one sub-column for the arrangement of Fig. 13;
- Fig. 16: shows the orientation of apertures suitable to write cuts in two directions;
- Fig. 17: shows an arrangement of columns in a cross sectional view for a rectangular arrangement for the layout of Fig. 16;
- Figs. 18 and 19: illustrates two consecutive exposures of a wafer with the arrangement of columns of Figs. 16 and 17;
- Fig. 20: shows a plan view detail of an aperture array plate having two aperture arrays with oblong and square apertures;
- Figs. 21A and 21B: illustrate the writing process with either of the two aperture arrays of Fig. 20;
- Figs. 22A and 22B: show plan view details of the deflection array plate corresponding to Figs. 21A and 21B, respectively;
- Fig. 23: shows a plan view detail of an aperture array plate having two aperture arrays with oblong apertures oriented along the two main directions, respectively; and
- Figs. 24A and 24B: show plan view details of the deflection array plate corresponding to exposure by a respective one of the two aperture arrays of Fig. 23;
- Figs. 25A and 25B: show plan view details of two array plates which together form a composite aperture array plate;
- Fig. 26: illustrates how the array plates of Figs 25A and 25B cooperate to form an oblong shape;
- Fig. 27: illustrates forming a different oblong shape with the same array plates;
- Fig. 28: shows yet another arrangement of columns in a cross sectional view at the level of the pattern definition device, for a rectangular arrangement with wide distance in the X direction; and
- Fig. 29: illustrates an exposure of a wafer with the arrangement of columns of Fig. 28.

### Detailed description of the invention

The embodiments shown in the following relate to a multi-beam tool for cutting patterns which is designed for mix-and-max lithography, where the substrate (e.g., silicon wafer) is exposed e.g. with a 193nm immersion scanner tool with die-fields having length DX and width DY of typically DX = 33mm and DY = 26mm. One die field may, and typically will, comprise several chips. The embodiments are not limiting, and thus the invention may refer to other layouts and applications as well; in particular, the values DX and DY and other dimensions presented here may be adapted as deemed suitable. Within this disclosure, the terms "upper", "lower" and related terms like "top" or "bottom" are to be understood with regard to the direction of the beam, which is thought to run downwards along a "vertical" axis. This vertical axis, in turn, is identified with the Z direction (longitudinal direction), to which the X and Y directions are transversal.

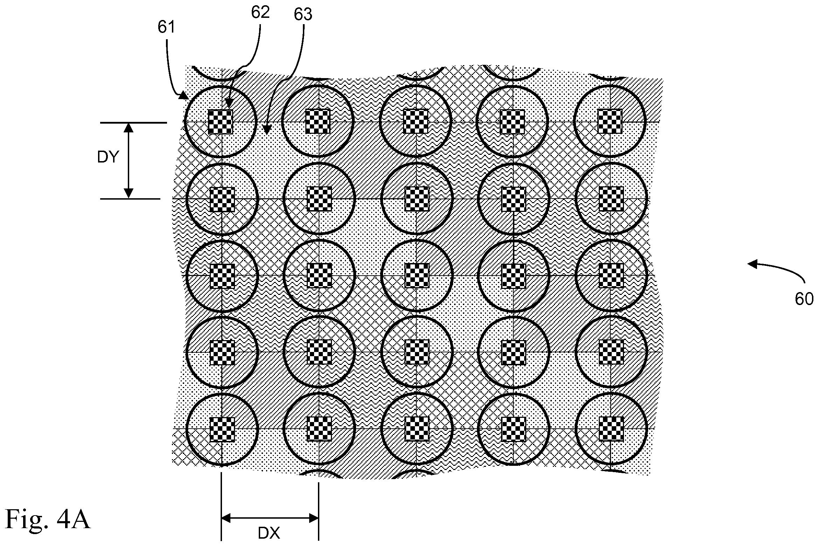

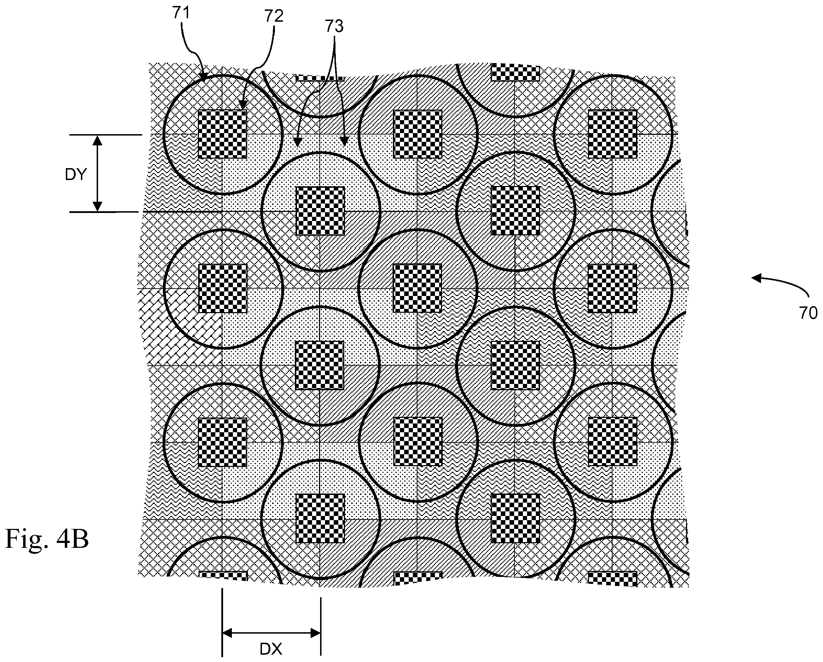

Examples of compact sub-columns arrangements 60 and 70 suitable for the invention are shown in Figs. 4A and 4B, respectively, which show plan view details of the arrangements with regard to the plane of the target. In Fig. 4A one sub-column 61 (symbolically represented by a circle) with an aperture array field 62 is used to expose the area 63 of one die field (as illustrated by different ways of hatching), whereas in Fig. 2B one sub-column 71 with an aperture array field 72 is used to expose the area 73 of two die fields.

Assuming DX = 33mm and DY = 26mm, then in case of Fig. 4A the diameter of a sub-column 61 is approx. 24mm and the size of the aperture array field 62 is approx. 8.2mm x 8.2mm, whereas in case of Fig. 4B the diameter of a sub-column 71 is approx. 40mm and the aperture array field 72 is approx. 16.4mm x 16.4mm. Assuming the periodicity of the apertures is 16µm, the aperture array field 62 is able to provide 512 x 512 = 262,144 beams, whereas the aperture array field 72 is able to provide 1024 x 1024 = 1,048,576 beams.

The aperture array field may also, in a variant, be chosen to be rectangular with the same diagonal length as a corresponding square aperture array field.

Based on detailed charged-particle optics simulations of the applicant, there is the possibility to generate sub-columns with an inner diameter of approx. 40mm when using an aperture array field of approx. 16.4mm x 16.4mm, and with an inner diameter of approx. 24mm when using an approx. 8.2mm x 8.2mm aperture array field. In both cases there is the possibility to obtain a very low (< 5nm 1sigma) beam blur, in particular when using 50keV electrons at the substrate and limiting the total current of the beams through the charged-particle projection optics to less than 1µA.

In AAP devices of the state of the art the apertures have quadratic shape, and also the corresponding larger apertures in the DAP and FAP have quadratic shape. This makes it possible to write even very complex patterns. Such complex patterns are needed e.g. for multi-beam mask writing. For mask writing the density of the patterns is usually very high, reaching up to, for instance, 75% of the total area. When writing leading-edge masks as needed for sub-20nm 193nm immersion optical lithography there is the necessity to write highly complex mask patterns as e.g. serifs (additional patterns at the corners), "strong" or "aggressive" OPC (optical proximity correction) patterns and, in particular for sub-15nm lithography, also ILT (inverse lithography technology) curvilinear patterns. Therefore, for such leading-edge masks the mask pattern density is well above 20%.

For complementary lithography at the substrate, the density of the cutting patterns is max. 10%, as outlined in Table 1. Further, the shape of the cuts are all rectangular, the smallest rectangle having dimensions of CA x CB with CA = L + 2nm and CB = 2 * CA, see Table 1. All larger rectangles are multiples of the smallest rectangle in the direction vertical to the regular line grid (see Fig. 3B).

### Multi-Beam Tool for exposing Cutting Patterns

The present invention proposes a pattern definition device (PDD) which is optimal for a multi-beam tool for cutting patterns. Furthermore, the invention enables to reach a maximum wafer throughput for a defined data path speed as provided to the PDD with a deflection array plate (DAP) with CMOS circuitry providing the switching speed as needed for the targeted throughput.

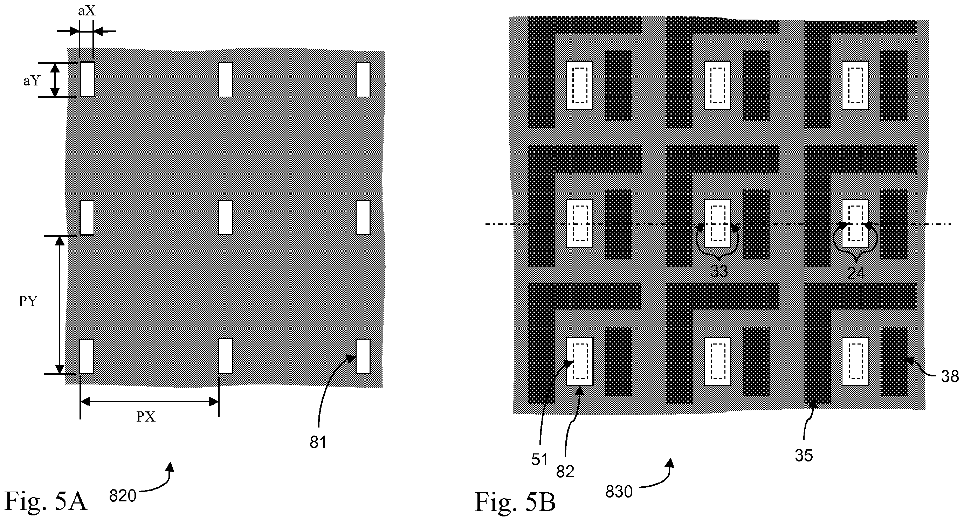

Figs. 5A and 5B show plan view details of an aperture array plate (AAP) and deflection array plate (DAP), respectively, which form part of a first embodiment of the invention. The first embodiment of the invention includes an AAP 820 with rectangular openings 81 of side lengths aX and aY arranged in an array having periodicity PX and PY, respectively. In the matching DAP 830, the corresponding openings 82 in the deflection array plate (DAP) are also rectangular but larger (for instance, approx. 2µm at each side) so that the rectangular beams 51 with side lengths aX and aY as formed by the AAP apertures 81 can pass through the corresponding apertures 82.

According to the invention, a suitable value of the ratio aY/aX is in the range between 2 and 4 (inclusive), preferable between 2 (exclusive) and 2.5, and typically 2.5 as outlined in the example of Fig. 5A.

The openings in the FAP may have a square or rectangular shape of adequate width (see figs. 2A and 2B) so that beams 51 and deflected beams 52 alike can pass through.

As an example, an AAP with rectangular aperture openings having aX = 1.6µm and aY = 4µm may be used to generate a cutting pattern with e.g. CA = 12nm and CB = 24nm as needed for the 5nm logic node (Table 1) with a line pattern of L = 10nm and P = 20nm. Using a projection optics with a reduction factor of R = 200, rectangular beams will expose corresponding images at the substrate with bX = 8nm and bY = 20nm side lengths at the silicon wafer substrate. Due to the aberrations of the charged-particle projection optics, the beams will be blurred and will have rounded ends. Because of charged particle forward scattering in the resist, resist blur and resist processing of widening of the developed resist patterns takes place. Using 50keV electrons and adequate resist materials and resist exposure dose (to minimize shot noise influences) a widening of typically 4nm is observed. Thus, the developed resist pattern will comprise shapes corresponding to the shapes shown in Fig. 3C with dimensions CEA=12nm and CAB=24nm. The overlay (OL) requirement of 3nm 3sigma for the 5nm logic node (Table 1) is evident from Fig. 3C.

Depending on the pattern placement requirements, different multi-beam exposure modes may be chosen. Multi-beam exposure techniques using overlapping beam shots are discussed in US 8,222,621 and US 7,276,714.

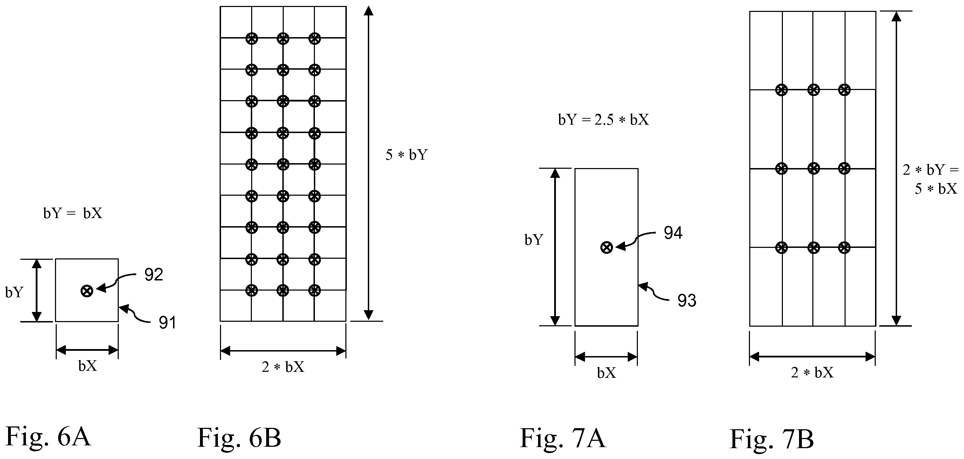

As an example shown in Fig. 6A, which corresponds to prior art method, the area of size 2·bX ∗ 5·bY shown in the figure is exposed in 27 shot exposures, using an overlap which is half of the beam size and using square shaped beams (denoted 91 in Fig. 6A) with dimensions bX and bY, with bY=bX. The centers 92 of the beam positions within the area shown on the target are indicated by symbols ⊗.

In contrast, an embodiment of the invention shown in Fig. 7A uses rectangular beams 93 with a beam size of bX * bY where bY = 2.5 * bX. Using an overlap of half of the beam size along both X and Y directions, respectively, as illustrated in Fig. 7B, the exposure of the same area as with Fig. 6B of 2∗5∗bX² needs 9 shots only. The centers 94 of the beam positions are again symbolized by symbols ⊗ (see Fig. 7A). Thus, using the invention, the throughput of a multi-beam tool for cutting patterns can be enhanced considerably, in the present example by a factor of 3.

When using a rectangular beam with shot overlap of half the beam size in X direction and Y direction, i.e. the physical grid size is half of the beam width in X and Y, respectively, a different address grid is obtained for placing the cutting pattern edges.

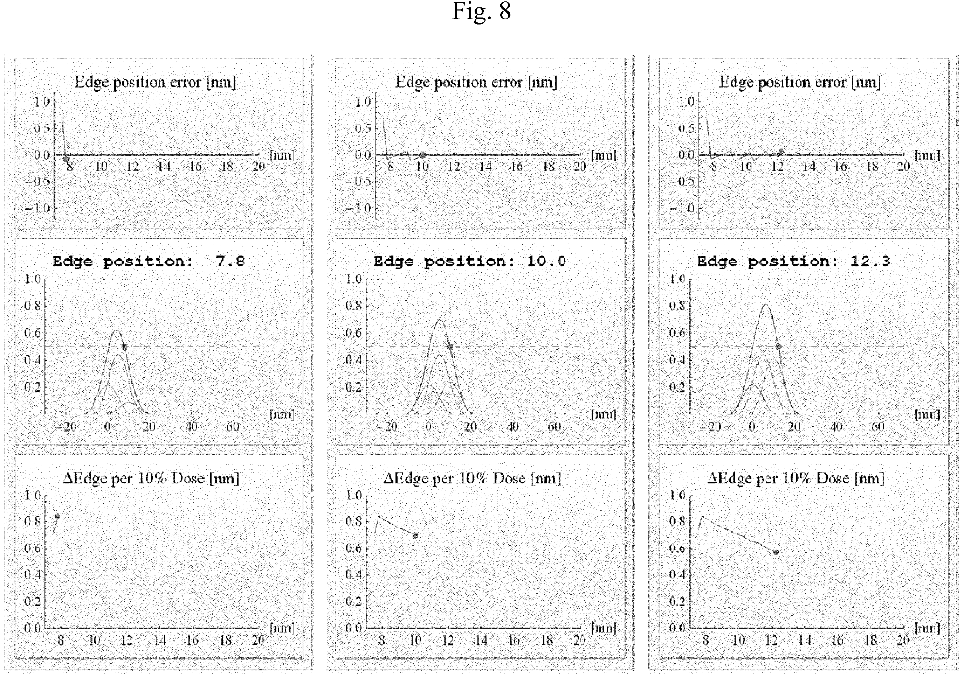

Fig. 8 illustrates the possibility to change the line width in very fine steps by simulation results of various intensity profiles, which correspond to different line widths in steps of 0.25nm. Examples of intensity profiles for 7.75nm, 10.0nm and 12.25nm line width are shown, corresponding to the left-hand, middle and right-hand column, respectively. In each column, the top frame shows the edge position error vs. line width, the middle frame the intensity profile, and the bottom frame shows the edge position deviation when enhancing the exposure dose by 10% vs. line width. The intensity profile simulations shown in Fig. 8 are, for instance, in the line grid direction D1 for 10nm shot width and 5nm physical grid, i.e. overlapping shots with half the beam size. A can be seen in the intensity profile frames in the middle row, the series starts with two overlapping shots where the right shot corresponds to the maximum exposure dose level, and the left shot with lower dose level is added to achieve a higher combined intensity profile (which has the form of an error function). The 0.5 level of the intensity profile (marked by a dashed line) is the local dose leading to resist development. The dose level of the left shot is chosen such that the left edge is at the position denoted 0nm. The right edge of the first simulation is at 7.5nm. In the next simulation a third shot is added with low dose level targeting to achieve a 7.75nm wide resist line. By changing the dose level of the third shot the simulations show that the line width is changed in 0.25nm steps up to 12.25nm line width. In Fig. 8 examples of intensity profile simulations for 7.75nm, 10.0nm, and 12.25nm line width, respectively, are shown. In the frames of the top row of Fig. 8, the deviations from the targeted edge positions are indicated. Apart from the case where the line width is 7.50nm, in all cases of line width between 7.75nm and 12.25nm the deviations of the line edge position are smaller than ±0.12nm.

The bottom row frames of Fig. 8 show the change of line edge position if the exposure dose would be changed by 10%. In a multi-beam tool for cutting patterns, the dose level will be kept at least within ± 1%. Thus, in all cases there is a change of line edge position of < 0.1nm taking a 1% uncertainty in exposure dose level into account.

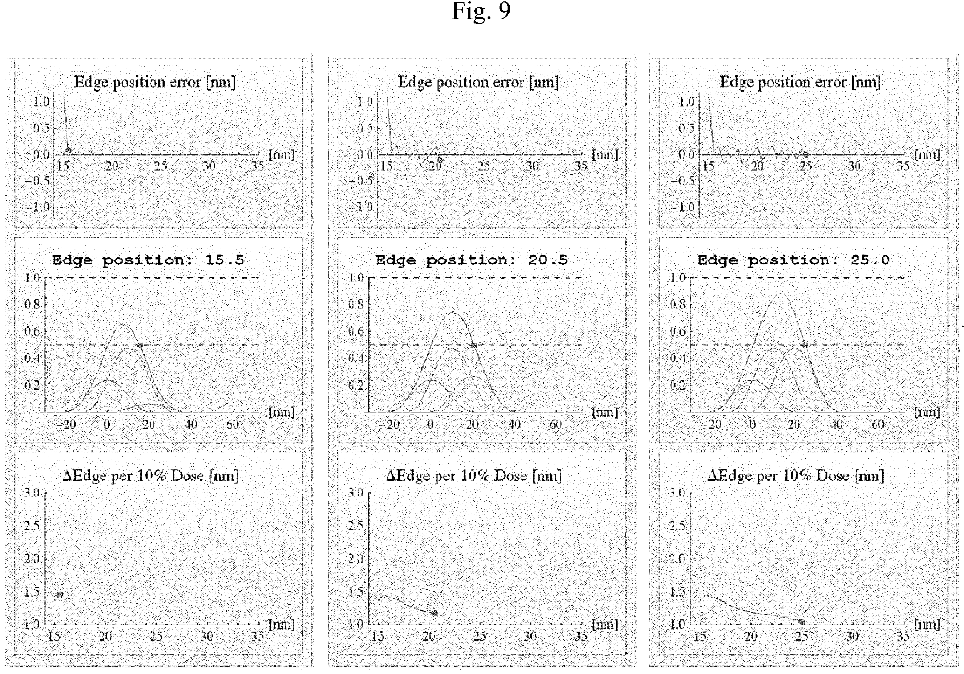

Fig. 9 shows simulation results of various intensity profiles in a depiction analogous to Fig. 8, but based on different line widths between 15.0nm and 25.0nm in steps of 0.5nm, for the situation along the cut direction D2 where the beam size is 20nm with a 10nm physical grid. Fig. 9 shows that the line width can be changed from 15.5nm to 25.0nm in steps of 0.5nm with deviations from the targeted line edge position of smaller than ± 0.2nm. The change of line edge position with 1% change of dose is < 0.15nm.

For the 10nm beam size simulations (profiles along cut direction D2) a better blur was assumed as compared to the simulations for the 20nm beam size (i.e., along line grid direction D1). This reflects a further aspect of the invention that by purpose the parameters of the charged-particle optical column are adjusted such that an improved resolution of the rectangular beam is achieved for bX. This improved resolution of the rectangular beam at the substrate in the small beam direction can be achieved by inducing an X-Y-astigmatism in the charged-particle optics, for instance by inducing a quadrupole field in electrostatic multipole electrodes positioned within the charged particle projection optics. This will cause that the resolution gets worse in the long beam direction and is improved in the direction of the small beam width. If the cut is to be produced in the other direction, then the quadrupole field is rotated by 90° to get the desired effect along the other direction.

Thus, it will be clear to the skilled person that the multi-beam exposure techniques described herein are suitable to fulfill the 3nm 3sigma CDU and 3nm 3sigma OL targets for the example of cutting pattern exposure for the 5nm Logic Node. Consequently, it will also be evident that the conditions can also be fulfilled for the 3nm Logic Node and even smaller Logic Nodes.

It should be mentioned that there is also the possibility to use a multi-beam exposure mode where the overlap between exposures takes a different value, such as a quarter of the beam width. An implementation of such a finer multi-beam exposure mode may be needed in case of requirements higher than those listed in Table 1 for the technology nodes indicated therein.

### Throughput of the Multi-Beam Tool for Cutting Patterns

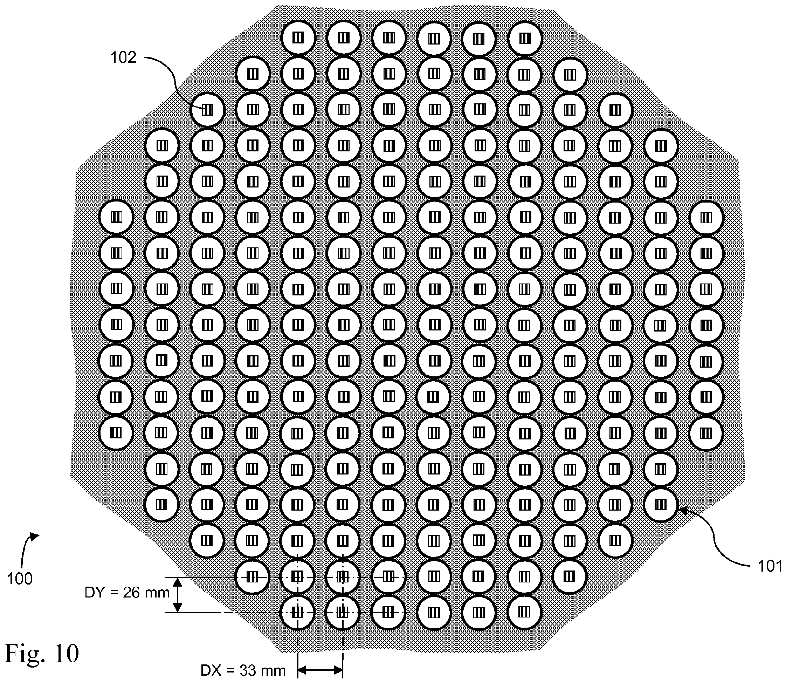

Fig. 10 illustrates an example of a column configuration of a multi-beam tool for cutting patterns. Shown is a cross sectional view outline at the level of the PDD device 12 of the multi-beam tool. The column configuration 100 is realized as an arrangement of sub-columns 101 with an inner diameter of e.g. 24mm (circles symbolize footprints of the sub-columns 101). The PDD devices of each sub-column have aperture array fields 102 of approx. 8.2mm x 8.2mm with rectangular apertures (Figs. 5A and 5B); the depiction of the aperture array fields in Fig. 10 is not to size. For exposing a 450mm wafer size, for instance, the column 100 will comprise 194 sub-columns 101 as shown in Fig. 10.

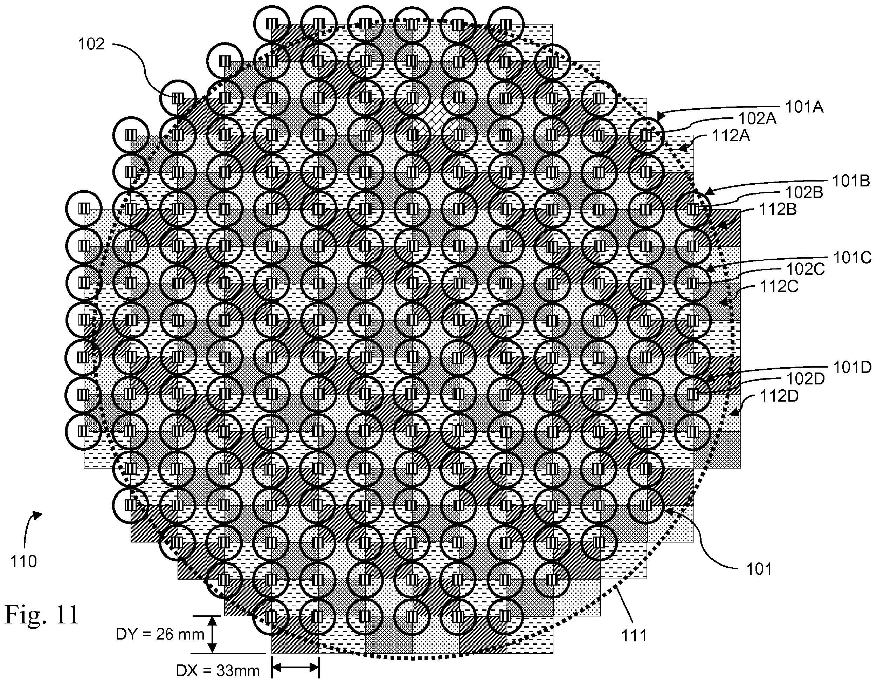

Fig. 11 shows the corresponding exposure 110 of the target exposure area 111 of a 450mm wafer for the case that DX = 33mm and DY = 26mm. The area on the target which is written by one column (column exposure area) is preferably just one die area. Thus, sub-column 101A with a PDD 102A will expose the die area 112A; sub-column 101B with a PDD 102B will expose the die area 112B; sub-column 101C with a PDD 102C will expose the die area 112C; sub-column 101D with a PDD 102D will expose the die area 112D; and so on.

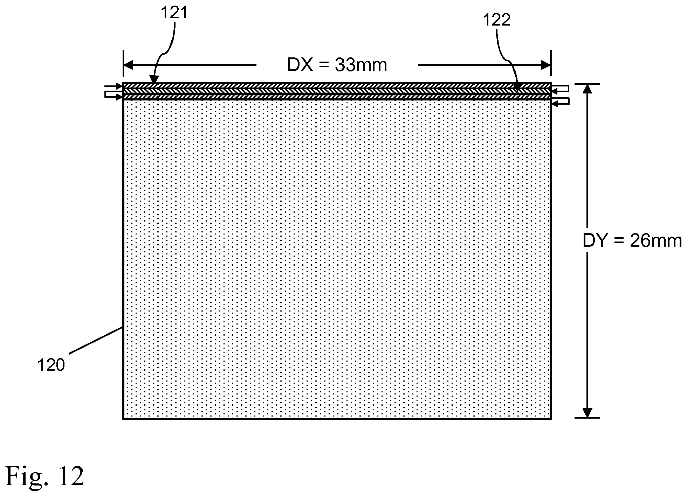

Fig. 12 illustrates the writing exposure of one die area by the sub-column. A die area 120 of dimensions DX * DY is preferably written in a meander of exposure stripes, i.e. in stripes 121 in +X direction and in stripes 122 in -X direction. When using an aperture field of, e.g., 8.2mm x 8.2mm and sub-columns providing 200:1 reduction, the beam array field at the wafer substrate is approx. 41µm x 41µm. An overlap of at least 1µm is allowed, so that with DY = 26mm there will be 650 exposure stripes. Doing the stripe exposure in a meander allows minimizing the number of stage returns.

As the sub-column exposures are done in parallel the movements necessary for writing the entire area of a 450mm wafer are ± 16.5mm in X-direction (for the exposure stripes which are 33mm long) and ± 13mm in Y-direction, covered during stepping from one stripe to the next. Only some small additional distances will have to be added for the stage returns in X-direction. Thus, since not the whole wafer area has to be scanned, the wafer stage for the multi-beam tool can be made in a very compact form, which is a significant advantage of the present invention.

Of course, the above-stated numbers and dimensions may be modified and adapted to the individual application and node sizes, as will be clear to the skilled person. In particular, for the exposure of 300mm silicon wafers a correspondingly smaller number of sub-columns will be needed.

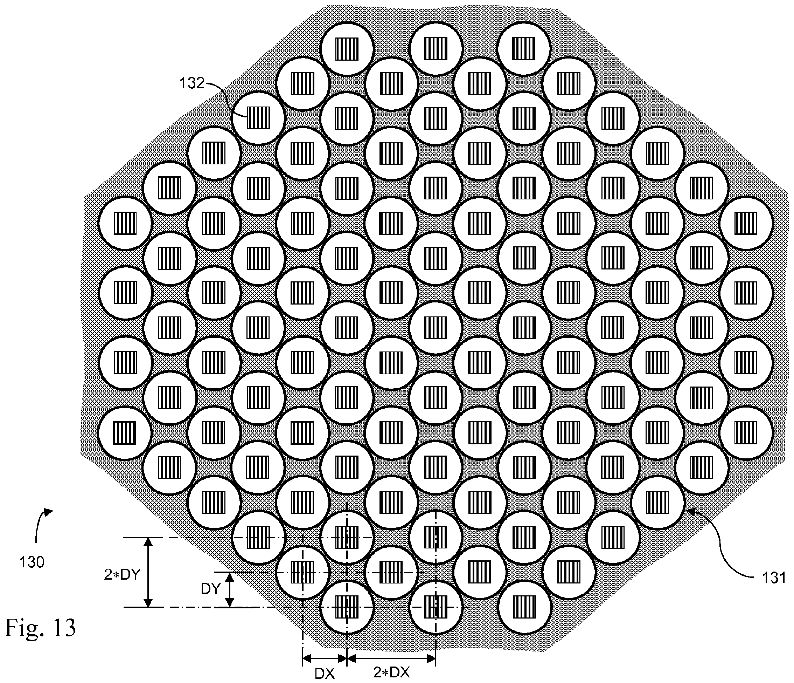

Fig. 13 shows another exemplary column configuration 130 where the sub-columns 131 have a pitch in X-direction of twice the length of the die field in X-direction (DX), and a pitch in Y-direction of twice the length of the die field in Y-direction (DY), corresponding to the layout shown in Fig. 4B. The sub-columns are "interleaved", i.e. the center of the next neighbored sub-column is in a direction not coinciding with the X or Y directions, such as at a combined distance of DX in X-direction and DY in Y-direction. For exposing a silicon wafer with 450mm diameter with die fields of DX = 33mm and DY = 26mm, for instance, a suitable column arrangement as shown in Fig. 13 may consist of 103 sub-columns 131 having an inner diameter of for instance 40mm. Within each sub-column there is a PDD 132 having an aperture array field of, e.g., 16.4mm x 16.4 mm with rectangular apertures (Figs. 5A and 5B).

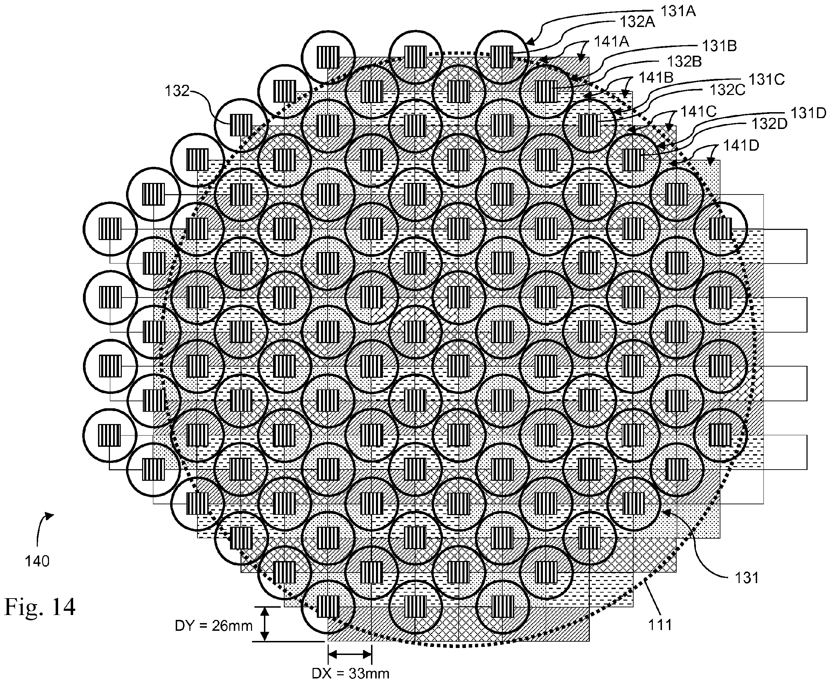

Fig. 14 illustrates the exposure 140 of the target exposure area of a 450mm wafer 111 employing the column configuration 130 of Fig. 13. This is done so as to have each sub-column expose a column exposure area of (2DX) * DY, as outlined in Fig. 4B. Thus, sub-column 131A with a PDD 132A will expose the area 141A; sub-column 131B with a PDD 132B will expose the area 141B; sub-column 131C with a PDD 132C will expose the area 141C; and sub-column 131D with a PDD 132D will expose the area 141D; and so on.

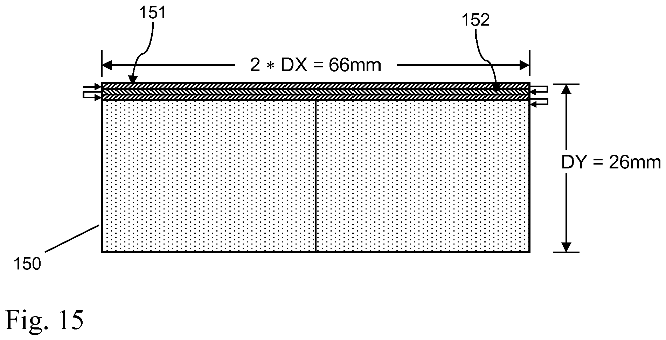

Referring to Fig. 15, the sub-column writing exposure of one of the areas 150 of dimensions (2DX) * DY is, again, preferably performed by means of a meander of exposure stripes 151, 152. The stripes 151 are made in +X direction, and stripes 152 in -X direction. When using an aperture field of, e.g., 16.4mm x 16.4mm and sub-columns providing 200:1 reduction, the beam array field at the wafer substrate is approx. 82µm x 82µm. An overlap of at least 2µm may be allowed, so that with DY = 26mm there will be 325 exposure stripes of 80µm width and 66mm length.

As the sub-column exposures are done in parallel the movements required for writing the area of a 450mm wafer are ± 33mm in X-direction (for the exposure stripes of 66mm length) and ± 13mm in Y-direction, resulting from stepping from one stripe to the next. Only some small additional distances will have to be added for the stage returns in X-direction. Thus again, since not the whole wafer are has to be scanned, the wafer stage for the multi-beam tool for cutting patterns can be made in a very compact form, which is a significant advantage of the present invention.

Table 2 lists data for a multi-beam tool 450mm wafer throughput performance for two exemplary cases made possible by the invention. Case A denotes a configuration where a sub-column exposes the area of two die fields (66mm x 26mm), and Case B a configuration where a sub-column exposes one die field area (33mm x 26mm).

**Table 2**

| | Case A: Sub-Column exposing two Die Fields (66mm x 26mm) | Case B: Sub-Column exposing one Die Field (33mm x 26mm) |
|---|---|---|
| Beam Energy and Particle Species | 50 keV electrons | 50 keV electrons |
| Sub-Column Diameter | ca. 40 mm | ca. 24 mm |
| Number of Sub-Columns | 103 | 194 |
| Aperture Array Field | ca. 16.4 mm x 16.4 mm | ca. 8.2 mm x 8.2 mm |
| Number of Programmable Beams | 1,048,576 (1024 x 1024) | 262,144 (512 x 512) |
| Data Path Speed | 240 Gbits/ s | 120 Gbits/ s |
| Address Grid along Line Grid Direction | 0.15 nm | 0.15 nm |
| Address Grid along Cut Direction | 0.50 nm | 0.50 nm |
| Beam size at wafer substrate | 8nm x 20nm | 8nm x 20nm |
| Current Density at wafer substrate | 2 A/cm² | 4 A/cm² |
| Current per Beamlet | 3.2 pA | 6.4 pA |
| Current through Column (max 10% of beams "on") | 0.34 µA | 0.17 µA |
| Resist Exposure Dose | 130 µC/cm² | 130 µC/cm² |
| Beam Array Field | ca. 82 µm x 82 µm | ca. 41 µm x 41 µm |
| Stage Velocity | 29.3 mm/s | 29.3 mm/s |
| Scanning Stripe Width | 80 µm (ca. 2 µm overlap) | 40 µm (ca. 1 µm overlap) |
| Exposure Area per Sub-Column | 66 mm x 26 mm | 33 mm x 26 mm |
| Number of Exposure Stripes per Sub-Column | 325 | 650 |
| Throughput without overhead | 5 WPH (450mm Si Wafer) | 5 WPH (450mm Si Wafer) |
| Throughput incl 25% overhead | 4 WPH (450mm Si Wafer) | 4 WPH (450mm Si Wafer) |

For a given data path speed, Case B can provide twice the throughput of Case A. With 25% overheads (wafer change and alignment, exposure overhead, stage return overhead), the resulting throughput is 4 WPH (300mm or 450mm silicon wafers per hour, with corresponding number of sub-columns).

Table 3 lists the data for a tool using this modified multi-beam exposure mode. As can be seen, the wafer throughput can be enhanced to 8 WPH (incl. 25% overhead), for Case B with 240 Gbits/s data path speed and 4 A/cm² current density. Despite of having 20% of the programmable beams "on" the current through the column is < 0.5µA.

**Table 3**

| | Case A: Sub-Column exposing two Die Fields (66mm x 26mm) | Case B: Sub-Column exposing one Die Field (33mm x 26mm) |
|---|---|---|
| Beam Energy and Particle Species | 50 keV electrons | 50 keV electrons |
| Sub-Column Diameter | ca. 40 mm | ca. 24 mm |
| Number of Sub-Columns | 103 | 194 |
| Aperture Array Field | ca. 16.4 mm x 16.4 mm | ca. 8.2 mm x 8.2 mm |
| Number of Programmable Beams | 1,048,576 (1024 x 1024) | 262,144 (512 x 512) |
| Data Path Speed | 480 Gbits/s | 240 Gbits/s |
| Address Grid along Line Grid Direction | 0.15 nm | 0.15 nm |
| Address Grid along Cut Direction | 0.50 nm | 0.50 nm |
| Beam size at wafer substrate | 8nm x 20nm | 8nm x 20nm |
| Current Density at wafer substrate | 4 A/cm2 | 8 A/cm2 |
| Current per Beamlet | 6.4 pA | 12.8 pA |
| Current through Column (max 10% of beams "on") | 0.67 µA | 0.34 µA |
| Resist Exposure Dose | 130 µC/cm2 | 130 µC/cm2 |
| Beam Array Field | ca. 82 µm x 82 µm | ca. 41 µm x 41 µm |
| Stage Velocity | 58.6 mm/s | 58.6 mm/s |
| Scanning Stripe Width | 80 µm (ca. 2 µm overlap) | 40 µm (ca. 1 µm overlap) |
| Exposure Area per Sub-Column | 66 mm x 26 mm | 33 mm x 26 mm |
| Number of Exposure Stripes per Sub-Column | 325 | 650 |
| Throughput without overhead | 10 WPH (450mm Si Wafer) | 10 WPH (450mm Si Wafer) |
| Throughput incl 25% overhead | 8 WPH (450mm Si Wafer) | 8 WPH (450mm Si Wafer) |

It should be mentioned that the above are illustrative examples of possible multi-beam tool column configurations and wafer exposure strategies, which are not meant as restricting the invention to the examples given above. The skilled person can easily derive suitable adaptions, such as for writing 300mm silicon wafers. Further, the substrate may be a wafer of another material as e.g. GaAs or a substrate of square shape, such as e.g. a 6" glass plate covered with a conductive layer and resist.

Further it should be mentioned that the die field dimensions of DX = 33mm and DY = 26mm are for exemplary purpose as well, even though they were chosen in accordance with state-of-the-art optical lithography tools for wafer exposure. The multi-beam tool configuration can be adapted to other die field dimensions in a straightforward manner.

### Multi-Beam Tool for exposing Cutting Patterns in X and Y directions

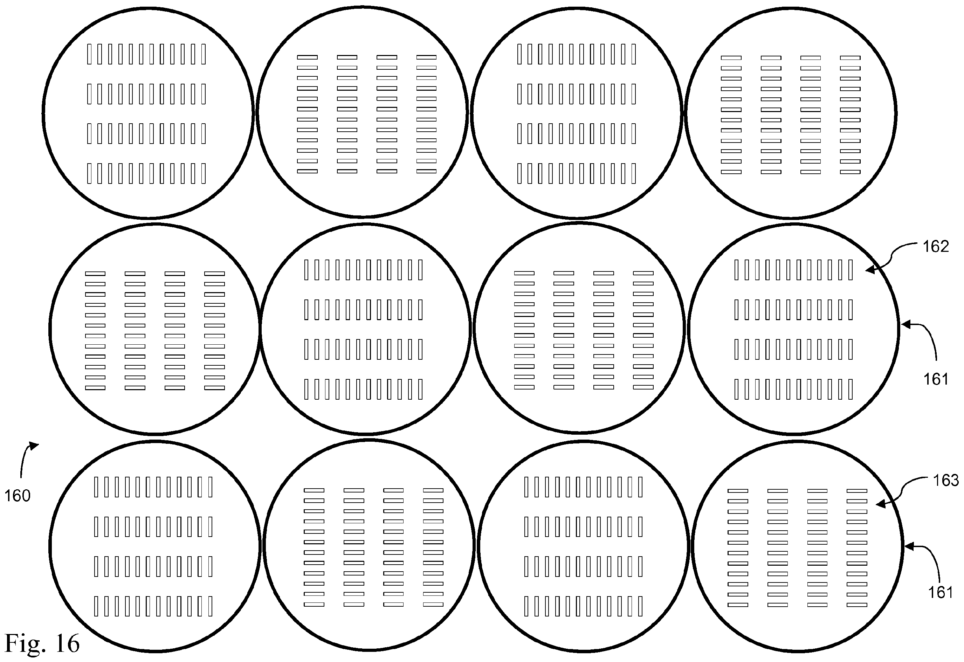

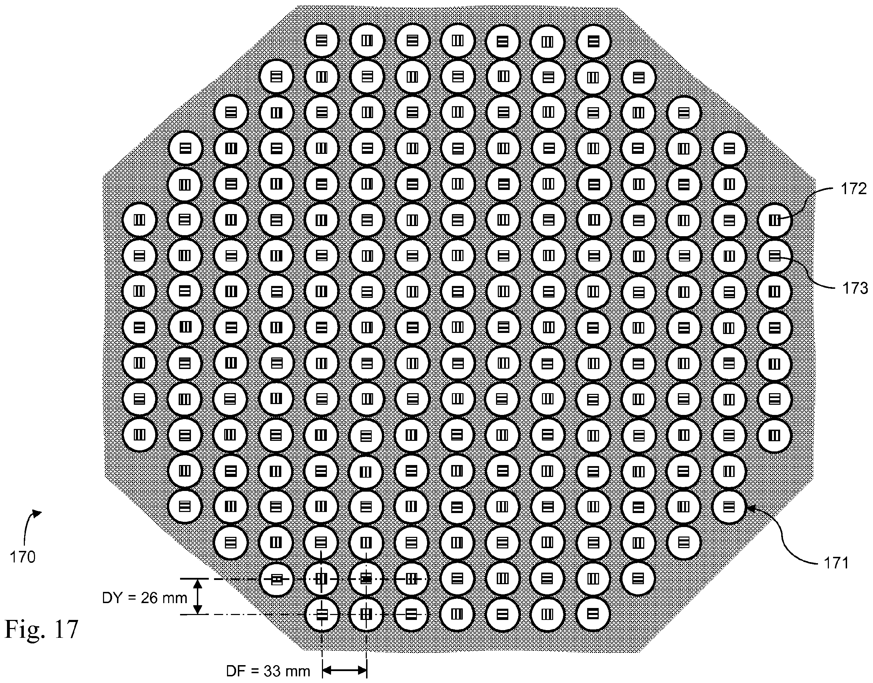

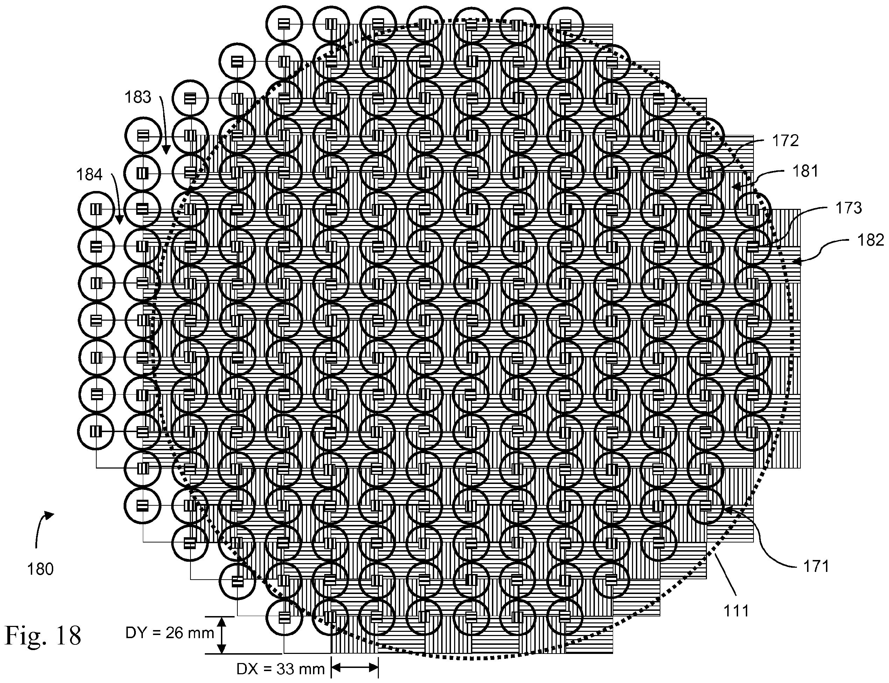

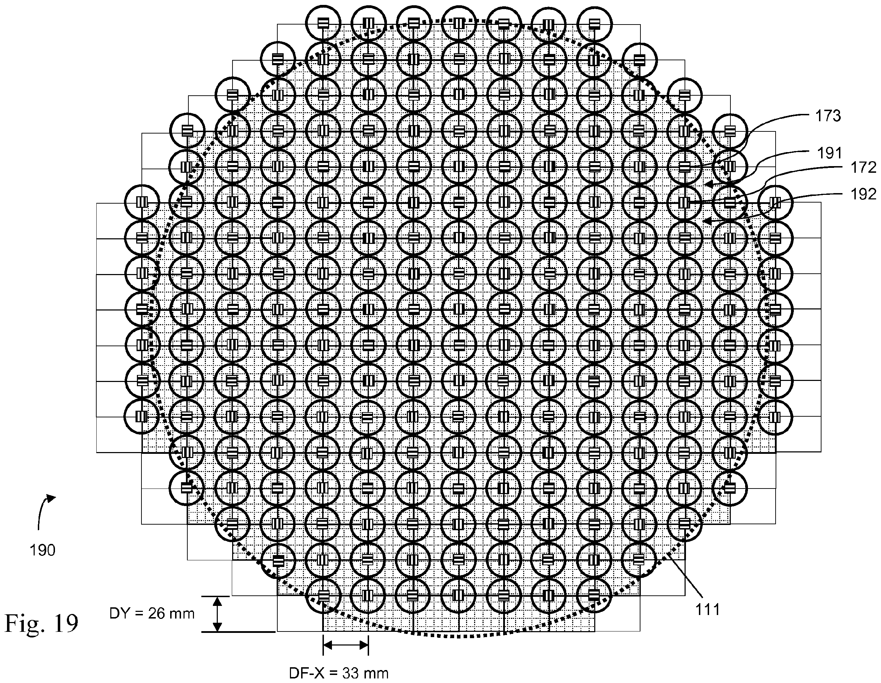

A further aspect of the invention addresses writing of cuts along more than one direction. Referring to Fig. 16, in the case that cutting in both X and Y directions is desired, it may be suitable to adopt a column configuration 160 with sub-columns 161 with pattern definition devices (PDD) where the aperture array field is either shaped for cuts in Y-direction 162 or for cuts in X-direction 163, respectively, for instance in an alternating manner as shown in Fig. 16. For example, in the case of sub-columns exposing one 33mm x 26mm die-field on 450mm silicon wafers, Fig. 17 shows a column configuration 170 with 211 sub-columns of e.g. 24mm inner diameter 171. The aperture array fields of for instance 8.2mm x 8.2mm are shaped either for cuts in X-direction 172 or for cuts in Y-direction 173. Fig. 18 illustrates the first wafer exposure 180 with cuts in X and Y direction according to the sub-column configuration 170 of Fig. 17, exposing (for instance) a specific die field 181 to produce cuts in Y-direction and for other specific die field 182 for cuts in X-direction. The fields 183 and 184 are kept unexposed. With a second wafer exposure 190 illustrated in Fig. 19 the cutting patterns are completed so as to comprise both directions, namely a die field 191 with exposure 173 and die field 192 with exposure 172. This is accomplished by moving the complete column configuration to a complementary configuration, in this example by an offset along the X direction, and thus all of the die fields are exposed with sub-columns of complementary cut configuration.

The multi-beam tool throughput for cutting patterns in both dimensions is approximately half of the multi-beam tool throughput as compared to when cutting patterns are realized in one dimension only. As the wafer is maintained on the chuck for both exposures there is only one wafer change time and one wafer alignment time needed.

### Multi-Beam Tool with in-situ change of Aperture Array Fields

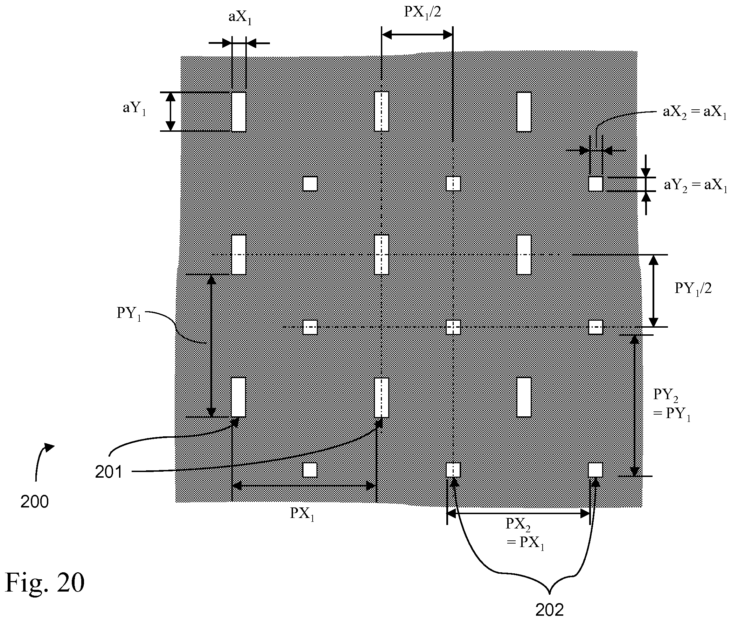

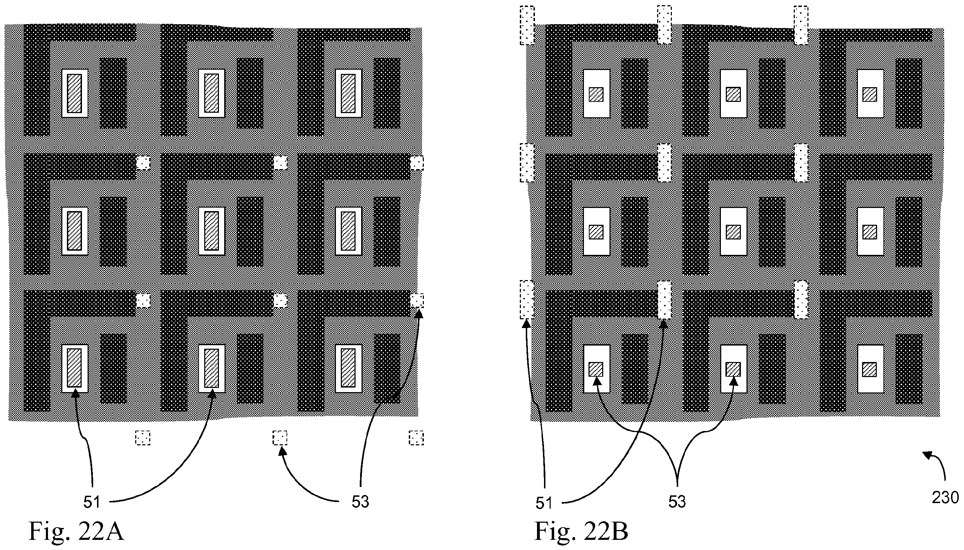

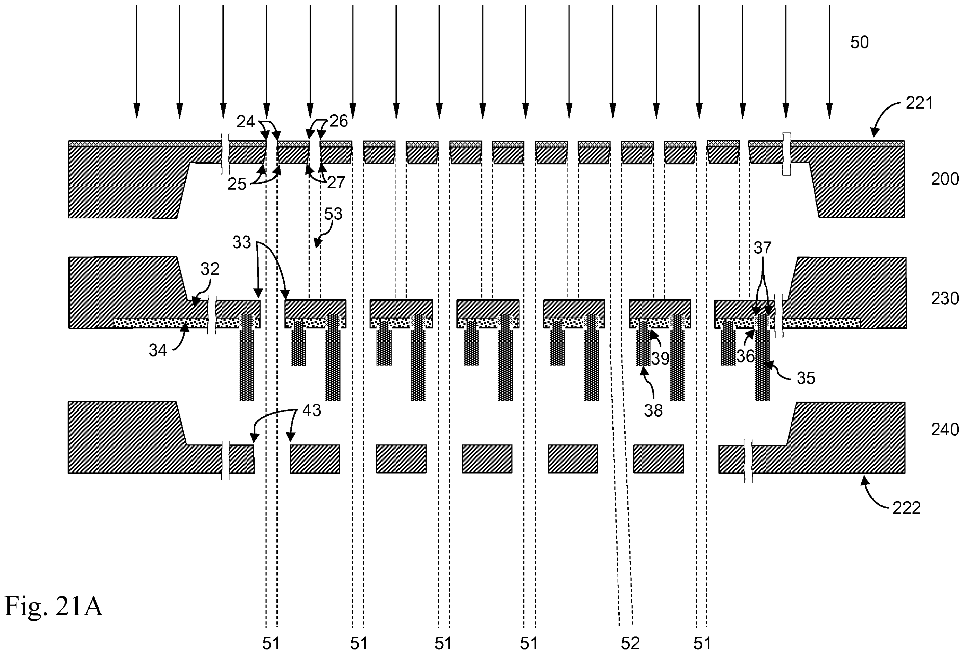

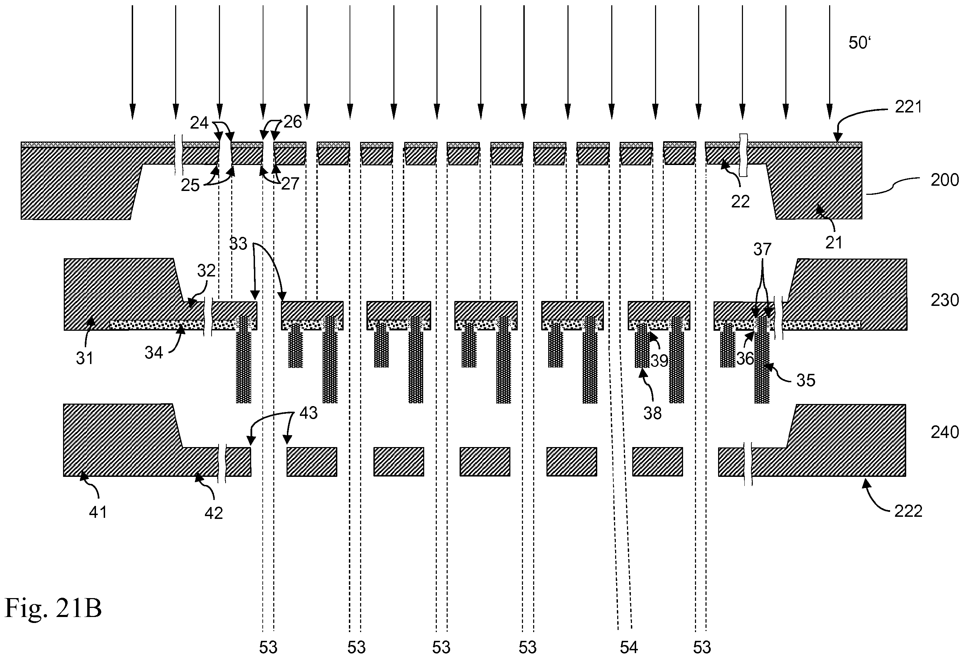

Figs. 20-22 illustrate a further development of the invention. In the AAP 200, of which Fig. 20 shows a detail plan view analogous to Fig. 5A, two (or more) sets of aperture openings 201 and 202 are provided. This development implements a concept similar to the one disclosed in US 8,546,767 of the applicant, but with a different layout of the aperture shapes for the novel use of enabling different writing procedures. For instance, the first set has rectangular openings, like those shown in Fig. 5A, with dimensions aX₁ and aY₁, whereas the second set has square openings with aY₂ = aX₂ = aX₁. Either of the two sets can be used in subsequent writing process steps, as illustrated in Figs. 21A and 21B (longitudinal sectional views analogous to Fig. 2B), as well as Figs 22A and 22B (detail plan views of the DAP 230 in correspondence with Fig. 20). Fig. 21A illustrates one process step exposing the cutting patterns with beams 51 formed by the rectangular openings 24 of the first set 201. The square openings 26 of the second set 202 will generate beams 53 which are blocked at one of the consecutive plates, for instance at the DAP 230. Fig 22A shows the situation at the DAP 230 in a corresponding plan view detail. For another writing process step, as illustrated in Figs. 21B and 22B, the AAP is shifted with respect to the other plates. As a consequence, the beams 51 are blocked whereas now the configuration allows beams 53 and deflected beam 54 to pass. Using the square beams 53 for exposure (Fig. 22B), highly complex patterns with same resolution in X and Y can be generated. Thus, this development of the invention enables that not only cutting patterns can be exposed with the multi-beam tool, but also complex patterns, albeit possibly at a lower throughput. It will be clear that in comparison to the aperture array with rectangular openings, the resolution at the substrate is better for the exposure through the small width apertures of the exposing beams. The FAP 240 will usually stay in fixed relative position with regard to the DAP 230; its openings are the same as, or preferably larger than, the corresponding openings 33 in the DAP 230.

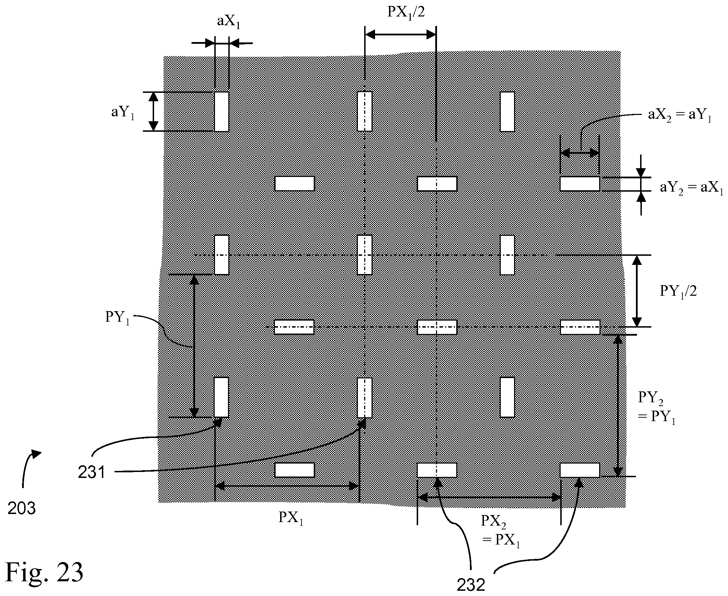

In a variant as illustrated in Fig. 23, the sets of apertures may both comprise rectangular openings, but with different orientations. This layout is particularly advantageous for chip designs where for different lithography layers line patterns are generated in different directions. Thus, there is the need to induce cutting patterns in one direction for a specific lithography layer and to induce cutting patterns in the other direction for another lithographic layer. With this, it will be possible to create a multi-beam tool which is flexible to expose cutting patterns in X or Y direction at highest possible throughput.

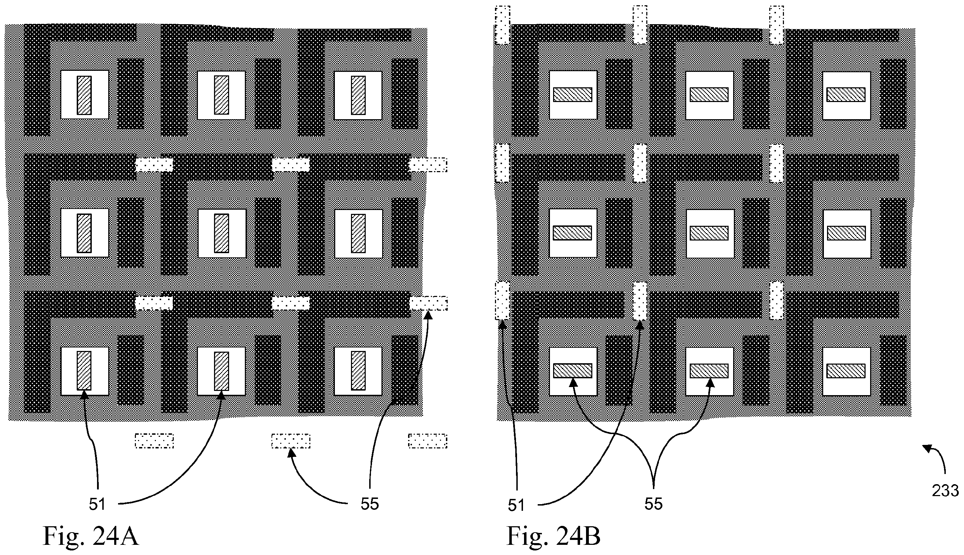

In accordance with this variant embodiment of the invention, Fig. 23 shows an AAP 230 having a layout comprising two sets 231 and 232 of rectangular aperture openings with dimensions aX₁, aY₁, and aX₂, aY₂ respectively. As indicated in the figure for this embodiment, aX₁ = aY₂ and aY₁ = aX₂; it will be clear, though, that the relation between the dimensions may be different in other embodiments since the size of the rectangular apertures of either or both sets may be varied as well. The AAP 203 can be positioned to different operating positions in relation to the corresponding DAP 233 so as to allow the passage of a selected one of the sets of aperture openings. In one position as illustrated in Fig. 24A, the beams 51 as generated by the set of aperture openings 231 are made available for cut exposure in Y direction. By means of a suitable X/Y shift of the AAP, a second position is selected as shown in Fig. 24B, wherein the beams 55 as generated with the set of aperture openings 232 are made available for cutting pattern exposure in X direction.

### Composite Aperture Array Device

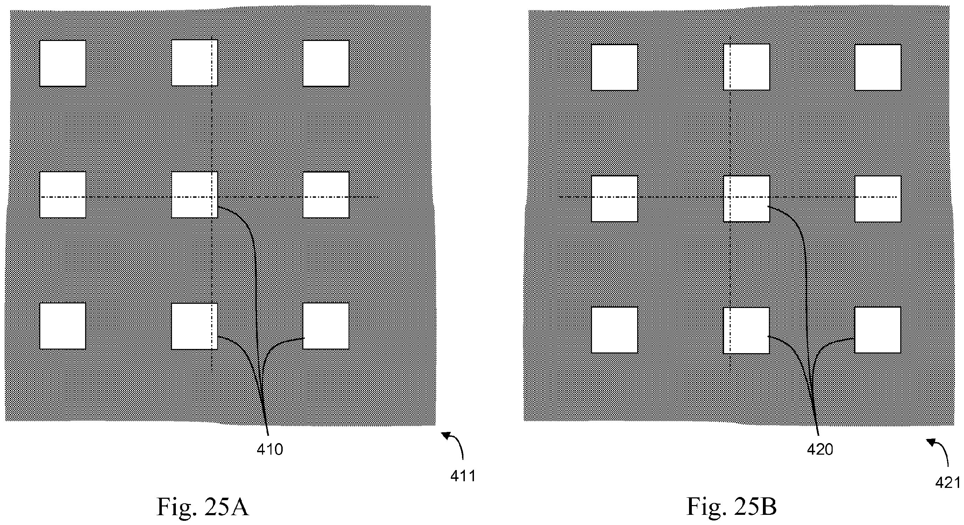

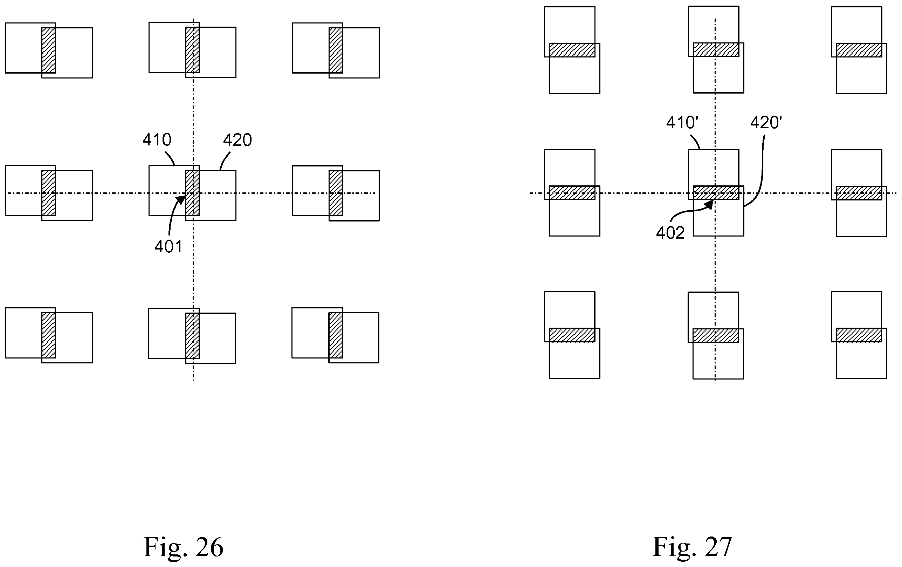

In another development of the invention illustrates in Figs. 25-27, a composite AAP comprises multiple, preferably two, plate devices 411, 421 which together define the apertures of the aperture array plate. As can be seen from the plan view details of Figs. 25A and 25B, each plate device 411, 421 is provided with an array of primary apertures 410, 420; the primary apertures of the plate devices cooperate to define the shape of the beamlets, as illustrated in Fig. 26. (Each of Figs. 25-27 shows an area comprising 3x3 apertures.) The plate devices are arranged consecutively and parallel within the PDD, preferably in immediate order (i.e., no other components are positioned between the plate devices). The plate devices are provided with actuators (not shown), for instance piezo actuators, which enable an adjustment of the mutual position of the plate devices transversal to the beam direction. Suitable actuators are known to the skilled person (for instance, see US 8,546,767 of the applicant).

The shape of the apertures 410, 420 of the plate devices 411, 421 are, for instance, squares of a common side length. Suitably, this side length is longer than the maximum side length of the oblong shapes to be defined using the apertures 410, 420. Referring to Fig. 26, a desired oblong shape 401 (hatched area) is defined by superposing the apertures 410, 420 such that two sides of the shape 401 is defined by two of the edges of one of the apertures 410, 420. The proper choice of a shape is achieved by suitable adjustment of the relative position of the plate devices 411,421 transversal to the beam direction. Thus, it is possible to define different shapes as well as different orientations by means of the same set of plate devices. For instance, as illustrated in Fig.27, an oblong shape 402 which has an orientation orthogonal to that of the shape 401 of Fig. 26 is easily obtained by readjusting the plate devices 410', 420' to a modified relative position.

### Multi-Beam Tool with Non-Compact Sub-Column Arrangement

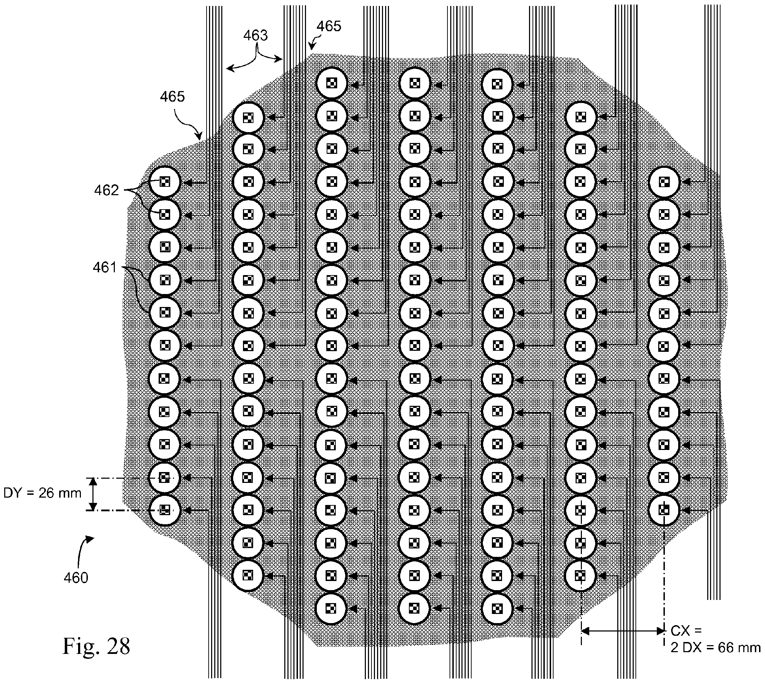

Fig. 28 shows yet another exemplary column configuration 460 where the sub-columns 461 are arranged in rows which are spaced apart from each other by an enlarged distance, for instance doubled as compared to the arrangement of Fig. 10, so as to form aisles 465 between the columns rows. Thus, the sub-columns 461 have an incremented pitch CX in X-direction, but a simple pitch in Y-direction (DY). A suitable choice is such that the pitch CX is the double of the pitch between adjacent sub-columns; the latter pitch here corresponds to the simple pitch in Y-direction (DY). In other embodiments (not shown), the pitch could be even higher. In other words, the pitch CX may be chosen two be (at least) twice the length of the die field in X-direction (DX), while a simple pitch in Y-direction (DY) is maintained. For exposing a silicon wafer with 450mm diameter with die fields of DX = 33mm and DY = 26mm, for instance, a suitable column arrangement as shown in Fig. 28 may comprise 103 sub-columns 461 having an inner diameter of for instance 24 mm. Within each sub-column there is a PDD 462 having an aperture array field of, e.g., 8.2 mm x 8.2 mm with rectangular apertures as discussed above.

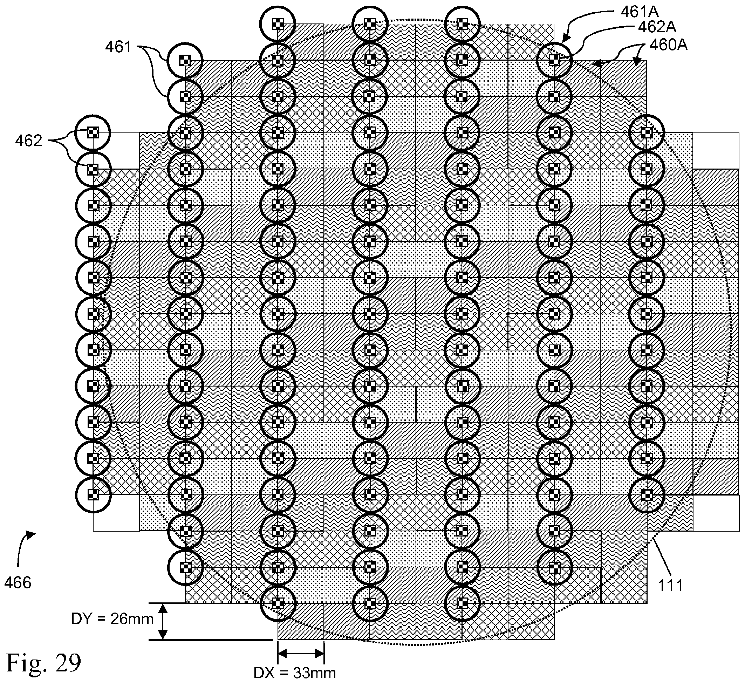

Fig. 29 illustrates the exposure 466 of the target exposure area of a 450mm wafer 111 employing the column configuration 460 of Fig. 28. This is done so as to have each sub-column expose a column exposure area of (2*DX) * DY, similar to Fig. 4A but with a doubled area for each column. Thus, for instance sub-column 461A with a PDD 462A will expose the area 460A, and so on (areas are denoted by their hatchings). The writing exposure of these area corresponds to what is discussed above with reference to Fig. 15.

This arrangement of sub-columns is not compact in at least one of the directions, for example along the X-direction, which offers the advantage of ease of providing the data path 463 to each sub-column as symbolized in Fig. 28 using the aisles 465 (in the example, along the Y-direction) between the rows of sub-columns. It may be seen as a disadvantage that each sub-column in the arrangement of Fig. 28 has to expose two die fields as outlined in Fig. 29; this may be compensated by providing a higher data path speed leading to a higher scanning stripe velocity. With this, in order to realize a specific exposure dose it is possible to increase either the current density, or the number of programmable beams within the beam array field 462 (Fig. 29).

Depending on the multi-beam exposure task, the PDD 462 in Fig. 48 may be shaped as outlined above with reference to Figs. 5A and 5B, Figs. 20 and 22, and/or Fig. 25-27.

## Claims

1. A charged-particle multi-beam processing apparatus (1) for exposure of a target (7) with a plurality of beams of electrically charged particles, comprising a plurality of particle-optical columns (9) arranged parallel and configured for directing a respective particle beam towards the target (7), the apparatus being configured to perform the exposure of said target (7) with respect to a predetermined line grid direction (D1), with said target (7) comprising a line pattern oriented along said line grid direction (D1), wherein each particle-optical column comprises:
- an illumination system (11),
- a beam shaping device (12) and
- a projection optics system (16),
the illumination system (11) being configured to produce a respective beam and form it into a substantially telecentric beam illuminating the beam shaping device, the beam shaping device (12) being configured to form the shape of the illuminating beam into a desired pattern composed of a multitude of sub-beams, and the projection optics system (16) being configured to project an image of the beam shape defined in the beam shaping device onto the target (7), wherein each beam shaping device (12) includes
- an aperture array device (200, 203) provided with an array of apertures, said array of apertures comprising a multitude of apertures (24, 26, 81, 201, 202, 231, 232), each of which defines the shape of a respective sub-beam having a nominal path towards the target (7), and
- a deflection array device (230, 233), configured to deflect selected sub-beams off their respective nominal path so that sub-beams thus selected do not reach the target,
wherein the apertures in said array of apertures are configured to form an oblong shape as seen along the direction of the beam, said oblong shape having a short (aX) and a long side (aY), with the long side being at least the double of the short side,
wherein the oblong shape formed by the apertures is oriented traversing said line grid direction (D1).

2. The apparatus of claim 1, wherein for each array of apertures the oblong shape of the apertures is uniformly oriented along a specific direction (D2, Y).

3. The apparatus of claim 2, wherein at least part of the aperture array devices are provided with at least two interlacing arrays of apertures (231, 232), wherein the oblong shapes within each array are uniformly oriented along a direction specific to the respective array, the specific directions of the arrays being mutually different.

4. The apparatus of claim 2 or 3, wherein at least part of the aperture array devices are provided with two interlacing arrays of apertures (231, 232), wherein the oblong shapes within a first array are uniformly oriented along a first direction, and within a second array along a second direction transversal to the first direction.

5. The apparatus of any of the preceding claims, wherein at least part of the aperture array devices are additionally provided with an array of non-oblong apertures (202), said non-oblong aperture having a shape differing from the shape of the oblong apertures, preferably square, circular or hexagonal, said array of non-oblong apertures interlacing with the array of oblong apertures.

6. The apparatus of claim 1, wherein for each column the oblong shape of the apertures is uniformly oriented within the respective aperture array device, wherein a first group of columns has the oblong shapes oriented along a first direction, and a second group has the oblong shapes oriented along a second direction transversal to the first direction, preferably orthogonal to the first direction.

7. The apparatus of claim 1 or 6, wherein for each column the projection optics system (16) projects an image onto the target (7) wherein the image includes an anisotropic blur, the projection optics system (16) being configured to generate an anisotropic blur having an axis of maximum blur oriented along a direction corresponding to the long side of the oblong shape of the apertures in the respective aperture array device.

8. The apparatus of any of the preceding claims, further comprising a target stage (5) for positioning target (7) with regard to the plurality of particle-optical columns (9), the target stage being configured to move the target through a sequence of positions, such that each column produces a set of images on the target within a predefined respective column exposure area (120, 150), wherein the column exposure areas of the columns combine into a covering of a target exposure area (111) on the target.

9. The apparatus of claim 8, wherein the column exposure area (120) of a column corresponds to an area of one die field on the target.

10. The apparatus of claim 8, wherein the column exposure area (150) of a column corresponds to an area of two adjacent die fields on the target.

11. The apparatus of any of the preceding claims, wherein the plurality of particle-optical columns (9, 461) are arranged in a two-dimensional arrangement (460) wherein along at least one direction of the two-dimensional arrangement the columns (461) are spaced apart by a column offset (CX) forming aisles (465), said column offset being at least the doubled width of a minimal pitch (DY) between adjacent columns.

12. The apparatus of any of the preceding claims, wherein the aperture array device comprises at least two consecutive plates (411, 421), arranged parallel within the beam shaping device and preferably in immediate order to each other, each plate having an array of apertures (410, 420) with the apertures of the plates mutually corresponding and cooperating to form a shape (401, 402) of the corresponding sub-beam, said shape being defined by the relative position of the plates as seen along the direction of the beam, said plates being provided with positioning devices to modify the relative position of the plates transversal to the direction of the beam.

13. The apparatus of any of the preceding claims, wherein in the columns the respective beam shaping device (12) includes
- a first boundary device (20, 200, 203) as the first element of the beam shaping device as seen along the direction of the beam, the first boundary device having a first surface (13, 221) oriented towards the illumination system (11),
- a final plate device (40, 240) as the last element of the beam shaping device as seen along the direction of the beam, the final plate device having a final surface (14, 222) oriented towards the projection optics system (16),
said first and final surfaces (13, 14, 221, 222) being flat with the exception of a respective array of openings corresponding to the apertures of the aperture array device (200, 203) of the respective beam shaping device (12).

14. The apparatus of claim 13, wherein the first boundary device is the aperture array device (200, 203) of the respective beam shaping device (12).

15. A method for exposure of a target (7) with a plurality of beams of electrically charged particles, using a charged-particle multi-beam processing apparatus (1) comprising a plurality of particle-optical columns (9) arranged parallel, wherein said target (7) comprises a line pattern oriented along a given line grid direction (D1),
wherein in each particle-optical column:
- a respective beam is produced in a respective illumination system (11) and formed into a substantially telecentric beam illuminating the beam shaping device,
- the shape of the illuminating beam is formed by a respective beam shaping device (12) into a desired pattern composed of a multitude of sub-beams, and
- an image of the beam shape defined in the beam shaping device is projected onto the target (7) by a respective a projection optics system (16),
wherein each beam shaping device (12) includes
- an aperture array device (200, 203) provided with an array of apertures, said array of apertures comprising a multitude of apertures (24, 26, 81, 201, 202, 231, 232), each of which defines the shape of a respective sub-beam having a nominal path towards the target (7), and
- a deflection array device (230, 233), configured to deflect selected sub-beams off their respective nominal path so that sub-beams thus selected do not reach the target,
wherein the apertures in said array of apertures form an oblong shape as seen along the direction of the beam, said oblong shape having a short (aX) and a long side (aY), with the long side being at least the double of the short side, and being oriented traversing said line grid direction (D1).

## Patentansprüche

1. Vielstrahl-Teilchenstrahl-Bearbeitungsgerät (1) zur Belichtung eines Target (7) mit einer Vielzahl von Strahlen elektrisch geladener Teilchen, umfassend eine Vielzahl von teilchenoptischen Säulen (9), die parallel angeordnet und dazu eingerichtet sind, jeweils einen Teilchenstrahl auf das Target (7) zu lenken, wobei das Gerät dazu eingerichtet ist, die Belichtung des Target (7) hinsichtlich einer vorbestimmten Liniengitter-Richtung (D1) durchzuführen, wobei das Target (7) ein Linienmuster aufweist, das entlang der Liniengitter-Richtung (D1) orientiert ist,
wobei jede teilchenoptische Säule umfasst:
- ein Beleuchtungssystem (11),
- eine Strahlformungsvorrichtung (12), und
- eine Projektionsoptik (16),
wobei das Beleuchtungssystem (11) dazu eingerichtet ist, einen jeweiligen Strahl zu erzeugen und in einen im Wesentlichen telezentrischen Strahl zu formen, der das Strahlformungsmittel beleuchtet, die Strahlformungsvorrichtung (12) dazu eingerichtet ist, die Form des beleuchtenden Strahles in ein gewünschtes Muster zu formen, das aus einer Vielheit von Teilstrahlen zusammengesetzt ist, und die Projektionsoptik (16) dazu eingerichtet ist, ein Bild der in dem Strahlformungsmittel definierten Strahlform auf das Target (7) zu projizieren,
wobei jede Strahlformungsvorrichtung (12) beinhaltet:
- eine Aperturenarrayeinrichtung (203) mit einem Array von Aperturen, welches eine Vielheit von Aperturen (24, 26, 81, 201, 202, 231, 232) aufweist, von denen jede die Form eines jeweiligen Teilstrahls mit einer nominellen Bahn zum Target (7) definiert, und
- eine Ablenkarrayeinrichtung (230, 330), die dazu eingerichtet ist, ausgewählte Teilstrahlen von ihrer jeweiligen nominellen Bahn abzulenken, sodass derart ausgewählte Teilstrahlen das Target nicht erreichen,
wobei die Aperturen in dem Array von Aperturen so eingerichtet sind, dass sie eine rechteckige Form entlang der Strahlrichtung gesehen bilden, wobei die rechteckige Form eine kurze (aX) und eine lange Seite (aY) aufweist, mit der langen Seite zumindest das Doppelte der kurzen Seite, wobei die von den Aperturen gebildete rechteckige Form quer zur Liniengitter-Richtung (D1) orientiert sind.

2. Gerät nach Anspruch 1, wobei für jedes Array von Aperturen die rechteckige Form der Aperturen einheitlich entlang einer bestimmten Richtung (D2, Y) orientiert ist.

3. Gerät nach Anspruch 2, wobei zumindest ein Teil der Aperturenarrayeinrichtungen mit zumindest zwei ineinandergreifenden Arrays von Aperturen (231, 232) ausgestattet sind, wobei die rechteckigen Formen in jedem Array einheitlich entlang einer für das jeweilige Array spezifischen Richtung orientiert sind, wobei die Richtungen der Arrays zueinander unterschiedlich sind.

4. Gerät nach Anspruch 2 oder 3, wobei zumindest ein Teil der Aperturenarrayeinrichtungen mit zumindest zwei ineinandergreifenden Arrays von Aperturen (231, 232) ausgestattet sind, wobei die rechteckigen Formen in einem ersten Array entlang einer ersten Richtung orientiert sind und in einem zweiten Array entlang einer zweiten Richtung quer zur ersten Richtung.

5. Gerät nach einem der vorhergehenden Ansprüche, wobei zumindest ein Teil der Aperturenarrayeinrichtungen zusätzlich mit einem Array nicht-länglicher Aperturen (202) ausgestattet sind, wobei diese nicht-längliche Apertur eine Form hat, die von der Form der rechteckigen Aperturen verschieden ist, vorzugsweise quadratisch, kreisförmig oder sechseckig, wobei das Array nicht-länglicher Aperturen mit dem Array von rechteckigen Aperturen ineinandergreift.

6. Gerät nach Anspruch 1, wobei für jede Säule die rechteckige Form der Aperturen in der jeweiligen Aperturenarrayeinrichtung einheitlich orientiert sind, wobei eine erste Gruppe von Säulen die rechteckigen Formen entlang einer ersten Richtung orientiert hat und eine zweite Gruppe die rechteckigen Formen entlang einer zweiten Richtung orientiert hat, die quer zu ersten Richtung verläuft, vorzugsweise orthogonal zur ersten Richtung.

7. Gerät nach Anspruch 1 oder 6, wobei bei jeder Säule die Projektionsoptik (16) ein Bild auf das Target (7) projiziert, wobei das Bild eine anisotrope Unschärfe aufweist, wobei die Projektionsoptik (16) dazu eingerichtet ist, eine anisotrope Unschärfe zu erzeugen, die eine Achse maximaler Unschärfe entlang einer Richtung, die der langen Seite der rechteckigen Form der Aperturen in der jeweiligen Aperturenarrayeinrichtung entspricht, aufweist.

8. Gerät nach einem der vorhergehenden Ansprüche, zudem aufweisend einen Target-Tisch (5) zum Positionieren des Target (7) in Bezug auf die Vielzahl von teilchenoptischen Säulen (9), wobei der Target-Tisch dazu eingerichtet ist, das Target durch eine Abfolge von Positionen zu bewegen, sodass jede Säule eine Menge von Bildern auf dem Target innerhalb eines jeweiligen vorbestimmten Säulen-Belichtungsgebiets (120, 150) erzeugt, wobei die Säulen-Belichtungsgebiete zu einer Überdeckung eines Target- Belichtungsgebiets (111) auf dem Target kombinieren.

9. Gerät nach Anspruch 8, wobei das Säulen-Belichtungsgebiet (120) einer Säule einem Gebiet eines Die-Felds auf dem Target entspricht.

10. Gerät nach Anspruch 8, wobei das Säulen-Belichtungsgebiet (120) einer Säule einem Gebiet von zwei nebeneinanderliegenden Die-Feldern auf dem Target entspricht.

11. Gerät nach einem der vorhergehenden Ansprüche, wobei die Vielzahl von teilchenoptischen Säulen (9, 461) in einer zweidimensionalen Anordnung (460) angeordnet sind, wobei die Säulen entlang zumindest einer Richtung der zweidimensionalen Anordnung um einen Säulen-Versatz (CX) beabstandet sind und Gänge (465) bilden, wobei der Säulen-Versatz zumindest das Doppelte eines minimalen Abstandsmaßes (DY) zwischen benachbarten Säulen ausmacht.

12. Gerät nach einem der vorhergehenden Ansprüche, wobei die Aperturenarrayeinrichtung zumindest zwei aufeinanderfolgende Platten (411, 421) umfasst, die parallel in der Strahlformungsvorrichtung und bevorzugt unmittelbar aufeinander folgend angeordnet sind, wobei jede Platte ein Array von Aperturen (419, 420) aufweist, die Aperturen der Platten wechselseitig korrespondieren und zum Ausbilden einer Form (401, 402) des zugehörenden Teilstrahls zusammenwirken, wobei diese Form durch die relative Position der Platten in Richtung des Strahls gesehen definiert wird, wobei die Platten mit Positioniervorrichtungen zum Verändern der relativen Position der Platten quer zur Richtung des Strahls ausgestattet sind.

13. Gerät nach einem der vorhergehenden Ansprüche, wobei in den Säulen die jeweilige Strahlformungsvorrichtung (12) umfasst:
- eine erste Begrenzungsvorrichtung (20, 200, 203) als das erste Element der Strahlformungsvorrichtung entlang der Strahlrichtung gesehen, wobei die erste Begrenzungsvorrichtung eine erste Oberfläche (14, 22) aufweist, die zum Beleuchtungssystem (11) hin orientiert ist,
- eine Endbegrenzungsvorrichtung (20, 200, 203) als das letzte Element der Strahlformungsvorrichtung entlang der Strahlrichtung gesehen, wobei die Endbegrenzungsvorrichtung eine abschließende Oberfläche (14, 22) aufweist, die zur Projektionsoptik (16) hin orientiert ist, wobei die erste und die abschließende Oberfläche (13, 14, 221, 222) flach sind, mit Ausnahme von jeweils einem Array von Öffnungen, die den Aperturen der Aperturenarrayeinrichtung (200, 203) der jeweiligen Strahlformungsvorrichtung (12) entsprechen.

14. Gerät nach Anspruch 13, wobei erste Begrenzungsvorrichtung die Aperturenarrayeinrichtung (200, 203) der jeweiligen Strahlformungsvorrichtung (12) ist.

15. Verfahren zum Belichten eines Target (7) mit einer Vielzahl von Strahlen elektrisch geladener Teilchen unter Verwendung eines Vielstrahl-Teilchenstrahl-Bearbeitungsgeräts (1) umfassend eine Vielzahl von teilchenoptischen Säulen (9), die parallel angeordnet sind, wobei das Target (7) ein Linienmuster aufweist, das entlang einer vorbestimmten Liniengitter-Richtung (D1) orientiert ist,
wobei in jeder teilchenoptischen Säule:
- jeweils ein Strahl in einem jeweiligen Beleuchtungssystem (11) erzeugt und in einen im Wesentlichen telezentrischen Strahl, der das Strahlformungsmittel beleuchtet, geformt wird,
- die Form des beleuchtenden Strahles durch eine jeweilige Strahlformungsvorrichtung (12) in ein gewünschtes Muster geformt wird, das aus einer Vielheit von Teilstrahlen zusammengesetzt ist, und
- ein Bild der in dem Strahlformungsmittel definierten Strahlform durch eine Projektionsoptik (16) auf das Target (7) projiziert wird,
wobei jede Strahlformungsvorrichtung (12) beinhaltet:
- eine Aperturenarrayeinrichtung (203) mit einem Array von Aperturen, welches eine Vielheit von Aperturen (24, 26, 81, 201, 202, 231, 232) aufweist, von denen jede die Form eines jeweiligen Teilstrahls mit einer nominellen Bahn zum Target (7) definiert, und
- eine Ablenkarrayeinrichtung (230, 330), die dazu eingerichtet ist, ausgewählte Teilstrahlen von ihrer jeweiligen nominellen Bahn abzulenken, sodass derart ausgewählte Teilstrahlen das Target nicht erreichen,
wobei die Aperturen in dem Array von Aperturen eine rechteckige Form entlang der Strahlrichtung gesehen bilden, wobei die rechteckige Form eine kurze (aX) und eine lange Seite (aY) aufweist, mit der langen Seite zumindest das Doppelte der kurzen Seite und quer zur Liniengitter-Richtung (D1) orientiert.

## Revendications

1. Appareil de traitement à faisceaux multiples de particules chargées (1) pour l'exposition d'une cible (7) à une pluralité de faisceaux de particules chargées électriquement, comprenant une pluralité de colonnes optiques à particules (9) agencées en parallèle et configurées pour diriger un faisceau de particules respectif vers la cible (7), l'appareil étant configuré pour réaliser l'exposition de ladite cible (7) par rapport à une direction de grille de lignes (D1) prédéterminée, ladite cible (7) comprenant un motif de lignes orienté le long de ladite direction de grille de lignes (D1), chaque colonne optique à particules comprenant :
- un système d'éclairage (11),
- un dispositif de mise en forme de faisceau (12) et
- un système d'optique de projection (16),
le système d'éclairage (11) étant configuré pour produire un faisceau respectif et le former en un faisceau sensiblement télécentrique éclairant le dispositif de mise en forme de faisceau, le dispositif de mise en forme de faisceau (12) étant configuré pour former la forme du faisceau d'éclairage en un motif souhaité composé d'une multitude de sous-faisceaux, et le système d'optique de projection (16) étant configuré pour projeter une image de la forme de faisceau définie dans le dispositif de mise en forme de faisceau sur la cible (7),
chaque dispositif de mise en forme de faisceau (12) comprenant
- un dispositif de réseau d'ouvertures (200, 203) comportant un réseau d'ouvertures, ledit réseau d'ouvertures comprenant une multitude d'ouvertures (24, 26, 81, 201, 202, 231, 232), dont chacune définit la forme d'un sous-faisceau respectif ayant un chemin nominal vers la cible (7), et
- un dispositif de réseau de déviation (230, 233), configuré pour dévier des sous-faisceaux sélectionnés de leur chemin nominal respectif de telle sorte que les sous-faisceaux ainsi sélectionnés n'atteignent pas la cible,
les ouvertures dans ledit réseau d'ouvertures étant configurées pour former une forme oblongue telle que vue le long de la direction du faisceau, ladite forme oblongue ayant un côté court (aX) et un côté long (aY), le côté long étant au moins le double du côté court,
la forme oblongue formée par les ouvertures étant orientée de manière à traverser ladite direction de grille de lignes (D1).

2. Appareil selon la revendication 1, dans lequel, pour chaque réseau d'ouvertures, la forme oblongue des ouvertures est uniformément orientée le long d'une direction spécifique (D2, Y).

3. Appareil selon la revendication 2, dans lequel au moins une partie des dispositifs de réseau d'ouvertures comportent au moins deux réseaux entrelacés d'ouvertures (231, 232), les formes oblongues dans chaque réseau étant uniformément orientées le long d'une direction spécifique au réseau respectif, les directions spécifiques des réseaux étant mutuellement différentes.

4. Appareil selon la revendication 2 ou 3, dans lequel au moins une partie des dispositifs de réseau d'ouvertures comportent deux réseaux entrelacés d'ouvertures (231, 232), les formes oblongues dans un premier réseau étant uniformément orientées le long d'une première direction, et dans un second réseau, le long d'une seconde direction transversale à la première direction.

5. Appareil selon l'une quelconque des revendications précédentes, dans lequel au moins une partie des dispositifs de réseau d'ouvertures comportent en outre un réseau d'ouvertures non oblongues (202), ladite ouverture non oblongue ayant une forme différant de la forme des ouvertures oblongues, de préférence carrée, circulaire ou hexagonale, ledit réseau d'ouvertures non oblongues étant entrelacé avec le réseau d'ouvertures oblongues.

6. Appareil selon la revendication 1, dans lequel, pour chaque colonne, la forme oblongue des ouvertures est uniformément orientée dans le dispositif de réseau d'ouvertures respectif, un premier groupe de colonnes ayant les formes oblongues orientées le long d'une première direction, et un second groupe ayant les formes oblongues orientées le long d'une seconde direction transversale à la première direction, de préférence orthogonale à la première direction.

7. Appareil selon la revendication 1 ou 6, dans lequel, pour chaque colonne, le système d'optique de projection (16) projette une image sur la cible (7), l'image comprenant un flou anisotrope, le système d'optique de projection (16) étant configuré pour générer un flou anisotrope ayant un axe de flou maximal orienté le long d'une direction correspondant au côté long de la forme oblongue des ouvertures dans le dispositif de réseau d'ouvertures respectif.

8. Appareil selon l'une quelconque des revendications précédentes, comprenant en outre une platine de cible (5) pour positionner la cible (7) par rapport à la pluralité de colonnes optiques à particules (9), la platine de cible étant configurée pour déplacer la cible à travers une séquence de positions, de telle sorte que chaque colonne produit un ensemble d'images sur la cible dans une zone d'exposition de colonne (120, 150) respective prédéfinie, les zones d'exposition de colonne des colonnes se combinant en une couverture d'une zone d'exposition de cible (111) sur la cible.

9. Appareil selon la revendication 8, dans lequel la zone d'exposition de colonne (120) d'une colonne correspond à une zone d'un champ de dé sur la cible.

10. Appareil selon la revendication 8, dans lequel la zone d'exposition de colonne (150) d'une colonne correspond à une zone de deux champs de dé adjacents sur la cible.

11. Appareil selon l'une quelconque des revendications précédentes, dans lequel la pluralité de colonnes optiques à particules (9, 461) sont agencées selon un agencement bidimensionnel (460) dans lequel, le long d'au moins une direction de l'agencement bidimensionnel, les colonnes (461) sont espacées d'un décalage de colonnes (CX) formant des allées (465), ledit décalage de colonnes étant au moins le double de la largeur d'un pas minimal (DY) entre des colonnes adjacentes.

12. Appareil selon l'une quelconque des revendications précédentes, dans lequel le dispositif de réseau d'ouvertures comprend au moins deux plaques consécutives (411, 421), agencées en parallèle dans le dispositif de mise en forme de faisceau et, de préférence, dans un ordre immédiat l'une par rapport à l'autre, chaque plaque ayant un réseau d'ouvertures (410, 420), les ouvertures des plaques étant mutuellement en correspondance et coopérant pour former une forme (401, 402) du sous-faisceau correspondant, ladite forme étant définie par la position relative des plaques telles que vues le long de la direction du faisceau, lesdites plaques comportant des dispositifs de positionnement pour modifier la position relative des plaques transversale à la direction du faisceau.

13. Appareil selon l'une quelconque des revendications précédentes, dans lequel, dans les colonnes, le dispositif de mise en forme de faisceau (12) respectif comprend
- un premier dispositif de limite (20, 200, 203) en tant que premier élément du dispositif de mise en forme de faisceau telle que vu le long de la direction du faisceau, le premier dispositif de limite ayant une première surface (13, 221) orientée vers le système d'éclairage (11),
- un dispositif de plaque finale (40, 240) en tant que dernier élément du dispositif de mise en forme de faisceau tel que vu le long de la direction du faisceau, le dispositif de plaque finale ayant une surface finale (14, 222) orientée vers le système d'optique de projection (16),
ladite première surface et ladite surface finale (13, 14, 221, 222) étant plates à l'exception d'un réseau respectif d'ouvertures correspondant aux ouvertures du dispositif de réseau d'ouvertures (200, 203) du dispositif de mise en forme de faisceau (12) respectif.

14. Appareil selon la revendication 13, dans lequel le premier dispositif de limite est le dispositif de réseau d'ouvertures (200, 203) du dispositif de mise en forme de faisceau (12) respectif.

15. Procédé pour l'exposition d'une cible (7) à une pluralité de faisceaux de particules chargées électriquement, à l'aide d'un appareil de traitement à faisceaux multiples de particules chargées (1) comprenant une pluralité de colonnes optiques à particules (9) agencées en parallèle, ladite cible (7) comprenant un motif de lignes orienté le long d'une direction de grille de lignes (D1) donnée,
dans lequel, dans chaque colonne optique à particules :
- un faisceau respectif est produit dans un système d'éclairage (11) respectif et formé en un faisceau sensiblement télécentrique éclairant le dispositif de mise en forme de faisceau,
- la forme du faisceau d'éclairage est formée par un dispositif de mise en forme de faisceau (12) respectif en un motif souhaité composé d'une multitude de sous-faisceaux, et
- une image de la forme de faisceau définie dans le dispositif de mise en forme de faisceau est projetée sur la cible (7) par un système d'optique de projection (16) respectif,
chaque dispositif de mise en forme de faisceau (12) comprenant
- un dispositif de réseau d'ouvertures (200, 203) comportant un réseau d'ouvertures, ledit réseau d'ouvertures comprenant une multitude d'ouvertures (24, 26, 81, 201, 202, 231, 232), dont chacune définit la forme d'un sous-faisceau respectif ayant un chemin nominal vers la cible (7), et
- un dispositif de réseau de déviation (230, 233), configuré pour dévier des sous-faisceaux sélectionnés de leur chemin nominal respectif de telle sorte que les sous-faisceaux ainsi sélectionnés n'atteignent pas la cible,
les ouvertures dans ledit réseau d'ouvertures formant une forme oblongue telle que vue le long de la direction du faisceau, ladite forme oblongue ayant un côté court (aX) et un côté long (aY), le côté long étant au moins le double du côté court, et étant orientée de manière à traverser ladite direction de grille de lignes (D1).
